(19) Europäisches Patentamt
European Patent Office
Office européen des brevets

(11) **EP 1 076 906 B1**

(12) **EUROPÄISCHE PATENTSCHRIFT**

(45) Veröffentlichungstag und Bekanntmachung des Hinweises auf die Patenterteilung:
**06.10.2004 Patentblatt 2004/41**

(51) Int Cl.[7]: **G21K 1/06**

(21) Anmeldenummer: **99923513.8**

(22) Anmeldetag: **04.05.1999**

(86) Internationale Anmeldenummer:
**PCT/EP1999/002999**

(87) Internationale Veröffentlichungsnummer:
**WO 1999/057732 (11.11.1999 Gazette 1999/45)**

(54) **BELEUCHTUNGSSYSTEM INSBESONDERE FÜR DIE EUV-LITHOGRAPHIE**

LIGHTING SYSTEM, ESPECIALLY FOR EXTREME ULTRAVIOLET LITHOGRAPHY

SYSTEME D'ECLAIRAGE NOTAMMENT POUR LA LITHOGRAPHIE A UV EXTREME

(84) Benannte Vertragsstaaten:
**DE FR GB IT NL**

(30) Priorität: **05.05.1998 DE 19819898**
**02.02.1999 DE 19903807**
**08.02.1999 DE 29902108 U**

(43) Veröffentlichungstag der Anmeldung:
**21.02.2001 Patentblatt 2001/08**

(73) Patentinhaber: **Carl Zeiss SMT AG**
**73447 Oberkochen (DE)**

(72) Erfinder:
• SCHULTZ, Jörg
  D-73430 Aalen (DE)
• WANGLER, Johannes
  D-89551 Königsbronn (DE)

(74) Vertreter: **Dr. Weitzel & Partner**
**Friedenstrasse 10**
**89522 Heidenheim (DE)**

(56) Entgegenhaltungen:
**US-A- 4 651 012      US-A- 5 339 346**
**US-A- 5 439 781      US-A- 5 581 605**
**US-A- 5 669 708      US-A- 5 737 137**

# EP 1 076 906 B1

**Beschreibung**

Die Erfindung betrifft ein Beleuchtungsssytem gemäß dem Oberbegriff des Anspruches 1 sowie eine Projektionsbelichtungsanlage mit einem derartigen Beleuchtungssystem und ein Verfahren zur Herstellung mikroelektronischer Bauelemente mit einer Projektionsbelichtungsanlage.

Um die Strukturbreiten für elektronische Bauteile noch weiter reduzieren zu können, insbesondere in dem Submikron-Bereich, ist es erforderlich, die Wellenlänge des für die Mikrolithographie eingesetzten Lichtes zu verringern. Denkbar ist bei Wellenlängen kleiner als 193 nm beispielsweise die Lithographie mit weichen Röntgenstrahlen, sog. EUV-Lithographie.

Ein für die EUV-Lithographie geeignetes Beleuchtungssystem soll mit möglichst wenigen Reflektionen das für die EUV-Lithographie vorgegebene Feld, insbesondere das Ringfeld eines Objektivs homogen, d.h. uniform ausleuchten, des weiteren soll die Pupille des Objektives feld unabhängig bis zu einem bestimmten Füllgrad σ ausgeleuchtet werden und die Austrittspupille des Beleuchtungssystems in der Eintrittspupille des Objektivs liegen.

Aus der US 5,339,246 ist ein Beleuchtungssystem für eine Lithographieeinrichtung, die EUV-Strahlen verwendet, bekanntgeworden. Zur gleichmäßigen Beleuchtung in der Retikelebene und Füllung der Pupille schlägt die US 5,339,246 einen Kondensor vor, der als Kollektorlinse aufgebaut ist und wenigstens vier paarweise Spiegelfacetten, die symmetrisch angeordnet sind, umfaßt. Als Lichtquelle wird eine Plasma-Lichtquelle verwendet.

In der US 5,737,137 ist ein Beleuchtungssystem mit einer Plasma-Lichtquelle umfassend einen Kondensorspiegel, gezeigt, bei dem mit Hilfe von sphärischen Spiegeln eine Ausleuchtung einer zu beleuchtenden Maske bzw. eines Retikels erzielt wird.

Die US 5,361,292 zeigt ein Beleuchtungssystem, bei dem eine Plasma-Lichtquelle vorgesehen ist und die punktförmige Plasma-Lichtquelle mit Hilfe eines Kondensors, der mindestens drei asphärische, außermittig angeordnete Spiegel aufweist, in eine ringförmig ausgeleuchtete Fläche abgebildet wird. Mit Hilfe einer speziellen nachgeordneten Abfolge von grazing-incidence-Spiegeln wird die ringförmig ausgeleuchtete Fläche dann in die Eintrittspupille abgebildet.

Aus der US 5,581,605 ist ein Beleuchtungssystem bekanntgeworden, bei dem ein Photonenstrahler mit Hilfe eines Wabenkondensors in eine Vielzahl von sekundären Lichtquellen aufgespalten wird. Hierdurch wird eine gleichmäßige bzw. uniforme Ausleuchtung in der Retikelebene erreicht. Die Abbildung des Retikels auf den zu belichtenden Wafer erfolgt mit Hilfe einer herkömmlichen Reduktionsoptik. Im Beleuchtungsstrahlengang ist genau ein gerasterter Spiegel mit gleich gekrümmten Elementen vorgesehen.

Die US 5,677,939 zeigt ein Beleuchtungssystem für EUV-Beleuchtungsanlagen, bei dem ein Ringfeld homogen ausgeleuchtet wird. Beim EUV-Beleuchtungssystem gemäß der US 5,677,939 werden die von der EUV-Quelle emittierten Strahlen zu einem parallelen Strahlenbüschel geformt, beispielsweise mit Hilfe eines Spiegels. Zur Ausbildung einer Vielzahl von sekundären Lichtquellen wird das parallele Strahlenbüschel auf einen Spiegel mit einer Vielzahl von Zylinderwaben geführt. Die US-A-5677939 beschreibt auch die Verwendung von Synchroton-Strahlungsquellen, allerdings wird wegen der Parallelität der austretenden Synchronstrahlung diese direkt auf den Spiegel mit Zylinderwaben geführt, ohne Zwischenschaltung von optischen Elementen. Sämtliche Ausführungsbeispiele der US 5,677,939 arbeiten im parallelen Strahlengang Zudem umfassen die aus der US 5,677,939 bekannten Facettenspiegel Facetten mit optischer Wirkung und sind auf einem Plansubstrat angeordnet.

Aus der US 5,512,759 ist ein Beleuchtungssystem für ein Ringfeld-Projektionssystem mit einer Synchroton-Strahlungsquelle bekanntgeworden, das ein Kondensorsystem mit einer Vielzahl von Sammefspiegeln umfaßt, die die von der Synchroton-Strahlungsquelle abgegebene Strahlung sammeln, zu einem ringförmigen Lichtstrahl formen, der mit dem ringförmig auszuleuchtenden Feld korrespondiert. Hierdurch wird das ringförmige Feld sehr gleichmäßig ausgeleuchtet. Die Synchrotron-Strahlungsquelle weist in der Abstrahlebene eine Strahldivergenz > 100 mrad auf.

Die US 5,439,781 zeigt ein Beleuchtungssystem mit einer Synchroton-Strahlungsquelle, bei der der lichtleitwert, d. h. die Lagrange optische Invariante mit Hilfe einer Streuscheibe in der Eintrittspupille des Objektives eingestellt wird, wobei die Streuscheibe eine Vielzahl von pyramidalen Strukturen aufweisen kann. Auch bei der US 5,439,781 weist die Synchrotron-Strahlungsquelle eine Strahldivergenz > 100 mrad auf. Der Kollektor-Spiegel zum Sammeln der Synchrotron-Strahlung und Bündeln derselben kann facettiert ausgebildet sein.

Der Offenbarungsgehalt sämtlicher zuvor genannten Schriften

US 5,339,246
US 5,737,137
US 5,361,292
US 5,581,605
US 5,677,939
US 5,512,759
US 5,439,781

wird in die vorliegende Anmeldung vollumfänglich aufgenommen.

Aufgabe der Erfindung ist es, ein möglichst einfach aufgebautes Beleuchtungssystem und ein Verfahren zum Design eines solchen anzugeben, mit dem die Anforderungen an ein Belichtungssystem für Wellenlängen ≤ 193 nm, insbesondere im EUV-Bereich erfüllt werden können. Insbesondere sollen neben einer uniformen Ausleuchtung des Retikels auch die Telezentrieanforderungen eines System für Wellenlängen ≤ 193 nm erfüllt werden.

Unter Telezentrie wird in der vorliegenden Anmeldung verstanden, daß das Gesamtsystem am Wafer telezentrisch ist. Dies erfordert eine Anpassung der Austrittspupille des Beleuchtungssystems an die Eintrittspupille des Objektives, die für ein reflektives Retikel im Endlichen liegen.

In der vorliegenden Anmeldung ist die Telezentrieanforderung dann erfüllt, wenn die Abweichung der Schwerstrahlen von Beleuchtung und Objektiv in der Retikelebene ein bestimmtes Maß, beispielsweise ± 4,0 mrad, vorzugsweise ±1,0 mrad nicht überschreitet und die Schwerstrahlen telezentrisch auf den Wafer treffen.

Erfindungsgemäß wird diese Aufgabe dadurch gelöst, daß bei einem oberbegrifflichen Beleuchtungssystem die Lichtquelle eine Lichtquelle zur Erzeugung von Strahlung mit einer Wellenlänge ≤ 193 mm ist, die in eine ausgezeichnete Ebene mit einem Wellenlängenspektrum abstrahlt, wobei der für die Anwendung, insbesondere die Lithographie verwendbare Wellenlängenbereich eine Strahldivergenz senkrecht zu dieser Ebene aufweist, die kleiner als 5 mrad ist.

Im EUV-Bereich finden als bevorzugte Lichtquellen mit einer Strahldivergenz kleiner als 5 mrad in der Ebene senkrecht zur ausgezeichneten Ebene Synchrotronstrahlungsquellen Verwendung. Synchronstrahlung wird emittiert, wenn relativistische Elektronen in einem Magnetfeld abgelenkt werden. Die Synchrotron-Strahlung wird tangential zur Elektronenbahn emittiert.

Bei Synchrotronstrahlungsquellen kann man derzeit drei Arten von Quellen unterscheiden:

- Bending-Magneten
- Wiggler
- Undulatoren

Bei Bending-Magnet-Quellen werden die Elektronen durch einen Bending-Magneten abgelenkt und Photonen-Strahlung emittiert.

Wiggler-Quellen umfassen zur Ablenkung des Elektrons bzw. eines Elektronenstrahles einen sogenannten Wiggler, der eine Vielzahl von aneinandergereihten abwechselnd gepolten Magnetpaaren umfaßt. Durchläuft ein Elektron einen Wiggler, so wird das Elektron einem periodischen, vertikalen Magnetfeld ausgesetzt; das Elektron oszilliert dementsprechend in der horizontalen Ebene. Wiggler zeichnen sich weiter dadurch aus, daß keine Kohärenzeffekte auftreten. Die mittels eines Wigglers erzeugte Synchrotronstrahlung ähnelt der eines Bending-Magneten und strahlt in einen horizontalen Raumwinkel ab. Sie weist im Gegensatz zum Bending-Magneten einen um die Anzahl der Pole des Wigglers verstärkten Fluß auf.

Der Übergang von Wiggler-Quellen zu Undulator-Quellen ist fließend.

Bei Undulator-Quellen werden die Elektronen im Undulator einem Magnetfeld mit kürzerer Periode und geringerem Magnetfeld der Ablenkpole als beim Wiggier ausgesetzt, so daß Interferenz-Effekte der Synchrotronstrahlung auftreten. Die Synchrotronstrahlung weist aufgrund der Interferenzeffekte ein diskontinuierliches Spektrum auf und strahlt sowohl horizontal wie vertikal in ein kleines Raumwinkelelement ab; d.h. die Strahlung ist stark gerichtet.

Sämtliche zuvor beschriebenen Synchrotron-EUV-Strahlungsquellen stellen bei geeigneter Dimensionierung EUV-Strahlung beispielsweise von 13 bzw. 11 nm mit ausreichender Leistung für die EUV-Lithographie zur Verfügung.

Betreffend Synchrotron-Strahlung wird auf Ernst Eckhart Koch, "Handbook of Synchrotron Radiation", 1983, Elsevier-Science, New York, verwiesen, wobei der Offenbarungsgehalt dieser Schrift in die vorliegende Anmeldung vollumfänglich mitaufgenommen wird.

Da sich die erfindungsgemäßen Strahlungsquellen zumindest in einer Ebene durch eine Strahldivergenz, die kleiner als 5 mrad ist, auszeichnen, sind mit Vorteil Mittel zur Strahlaufweitung beispielsweise ein Kollektorsystem vorgesehen.

Als Strahlaufweitungsmittel können in einer vorteilhaften Ausführungsform Zerstreuspiegel oder Scanspiegel, die eine vorbestimmte Bewegung zur Ausleuchtung einer Fläche durchführen, vorgesehen sein.

Da Feld und Apertur der Lichtquelle nicht ausreichen, um Feld und Apertur in der Retikelebene zu füllen bzw. zu beleuchten, umfaßt das erfindungsgemäße Beleuchtungssystem mindestens einen Spiegel oder eine Linse mit Rasterelementen zur Erzeugung einer Vielzahl von sekundären Lichtquellen, die in der Blendenebene gleichmäßig verteilt sind. Da die geometrische Ausdehnung der Rasterelemente des ersten Spiegels oder der ersten Linse die Form des ausgeleuchteten Feldes in der Retikelebene bestimmt, werden die Feldwaben bei einem ringförmigen Scan-Schlitz bevorzugt rechteckig ausgebildet. Die optische Wirkung der Rasterelemente des ersten Spiegels, die auch als Feldwaben bezeichnet werden, ist so ausgelegt, daß in der Blendenebene ein Bild der Lichtquelle entsteht, eine sogenannte sekundäre Lichtquelle. Ist die Ausdehnung der Lichtquelle gering, beispielsweise näherungsweise punktförmig, wie bei einer Undulator-Quelle, so ist auch die Ausdehnung der sekundären Lichtquelle gering, und alle Lichtstrahlen laufen nahezu durch einen Punkt. In jeder Ebene nach der Blendenebene entsteht dann ein Bild der Feldwabe, wobei der Abbildungsmaßstab durch das Verhältnis von Abstand Blende-Retikel zu Feldwabe-Blende gegeben ist. Die Feldwaben sind dabei so gekippt, daß sich die Bilder der Feldwaben in der Retikelebene zumindest zum Teil überlagern.

Die Abbildung der sekundären Lichtquellen in die Eintrittspupille des Objektivs geschieht vorteilhafterweise mit einem Feldspiegel bzw. einer Feldlinse, wobei die Feldlinse bzw. der Feldspiegel das Ringfeld durch Steuerung der Verzeichnung formt. Der Abbildungsmaßstab der Feldwabenabbildung wird dadurch nicht verändert.

Bei ausgedehnten Lichtquellen, wie beispielsweise einem Bending-Magneten, sind die sekundären Lichtquellen ausgedehnt, so daß das Bild der Feldwaben in der Retikelebene zerläuft. Ein scharfes Bild bei einem solchen System kann erreicht werden, wenn man einen zweiten Spiegel oder eine Linse mit Rasterelementen, d.h. eine sogenannte Doppelfacettierung, versieht, wobei die Rasterelemente des zweiten Spiegels oder der Linse, die sogenannten Pupillenwaben, am Ort der sekundären Lichtquellen, sitzen.

Bei Systemen mit zwei Spiegeln mit Rasterelementen ist die Form der Rasterelemente des zweiten Spiegels, d.h. der Pupillenwaben, an die Form der sekundären Lichquellen angepaßt und somit verschieden von der Form der ersten Rasterelemente, d.h. der Feldwaben. Besonders bevorzugt sind die Pupillenwaben rund, wenn auch die Lichtquelle rund ausgebildet ist.

Besonders bevorzugt ist es, wenn der erste Spiegel mit Rasterelementen rotationssymmetrisch bzw. rund ausgeleuchtet wird, da dann mit entsprechender Anordnung in der Blendenebene eine gleichmäßige Verteilung der sekundären Lichtquellen erreicht werden kann.

Ist die Ausleuchtung des ersten Spiegels hiervon abweichend, beispielsweise rechteckig, so wird bei einem derartigen System mit einer Doppelfacettierung die gewünschte runde Ausleuchtung der Eintrittspupille des Objektives erreicht.

Die den Spiegeln mit Rasterelementen nachgeordneten optischen Elemente dienen dazu, die Blendenebene des Beleuchtungssystems in die Eintrittspupille des Projetionsobjektives abzubilden, das Ringfeld zu formen. Des weiteren dienen sie dazu, die Beleuchtungsverteilung entsprechend den Anforderungen des Belichtungsprozesses zu erzeugen.

Besonders bevorzugt ist es, wenn die optischen Elemente grazing-incidence-Spiegel mit Inzidenzwinkel $\leq$ 20° umfassen. Um die mit jeder Reflektion verbundenen Lichtverluste zu minimieren, ist mit Vorteil vorgesehen, wenn die Anzahl der Feldspiegel gering gehalten wird. Besonders bevorzugt sind Ausführungsformen mit höchstens zwei Feldspiegeln.

Nachfolgend soll ein Zahlenbeispiel gegeben werden, aus dem die Notwendigkeit der Lichtleitwerterhöhung beispielhaft für den Fall einer Undulator-Quelle zu ersehen ist.

Fordert man eine Apertur in der Waferebene von $NA_{Water}$ = 0.1-0.25, so bedeutet dies bei 4:1 Systemen eine Apertur in der Retikelebene von $NA_{Retikel}$ = 0.025-0.0625. Soll das Beleuchtungssystem diese Apertur bis zu einem. Füllgrad von $\sigma$ = 0.6 homogen und feldunabhängig ausleuchten, so muß die EUV-Quelle über folgenden 2-dim-Lichtleitwert (LLW), d. h. Lagrange optische Invariante oder Etendu verfügen:

$$LLW_{Bel.} = \sigma^2 \, LLW_{Obj} = 0.149 \text{ mm}^2 - 0.928 \text{ mm}^2$$

verfügen. Der Lichtleitwert LLW, d. h. die Lagrange optische Invariante, ist wie folgt allgemein definiert:

$$LLW = x \cdot y \cdot NA^2 = A \cdot NA^2,$$

wobei A die ausgeleuchtete Fläche ist.

A beträgt in der Retikelebene z.B. 110 mm x 6 mm.

Als Lichtquelle für das erfindungsgemäße EUV-Beleuchtungssystem sei in einer ersten Ausführungsform eine Undulator-Quelle betrachtet.

Der Lichtleitwert, d. h. die Langrange optische Invariante oder Etendu, für die Undulator-Quelle läßt sich nach einem vereinfachten Modell bei Annahme eines homogenen Flächenstrahlers mit Durchmesser $\varnothing$ = 1,0 mm und Apertur $NA_{Und}$ = 0.001 mit

$$LLW = A \cdot NA^2$$

$$A_{Und} = \pi \cdot (\varnothing /2)^2$$

$$= 0.785 \text{ mm}^2$$

$$NA_{Und} = 0.001$$

zu

$LLW_{Und} = A \cdot NA^2 = 0.00000079 \text{ mm}^2 = 7.9\text{e-}07 \text{ mm}^2$ abschätzen. Wie aus dieser groben Abschätzung zu ersehen, ist der Lichtleitwert der Undulator-Quelle im Vergleich zum geforderten Lichtleitwert verschwindend klein.

Der Lichtleitwert, d. h. die Lagrange optische Invariante, kann durch die Erzeugung von sekundären Lichtquellen, die verteilt angeordnet sind, auf das erforderliche Maß in der Eintrittspupille des Objektives erhöht werden. Hierfür wird der erste Spiegel mit Rasterelementen ausgeführt. Die Ausleuchtung der Eintrittspupille eines Objektives wird durch den Füllfaktor definiert. Es gilt:

$$\text{Füllfaktor:} \quad \sigma = \frac{r_{Beleuchtung}}{R_{Objektivapertur}}$$

wobei

$R_{Objektivapertur}$:     Radius Eintrittspupille des Objektives ist
$r_{Beleuchtung}$:     Radius der Ausleuchtung der Feldwabenplatte bei annularer Ausleuchtung

Bei $\sigma = 1.0$ ist die Eintrittspupille vollständig gefüllt; $\sigma = 0.6$ entspricht einer Unterfüllung.

Da aufgrund des kleinen Lichtleitwertes der Undulator-Quelle die Teilpupillen scharfe Intensitäts-Peaks sind, ist es vorteilhaft, wenn diese mit Hilfe von "wobbelnden" Feldspiegel verschmiert werden, wobei die Feldausteuchtung dabei unberührt bleiben sollte. Deshalb ist es vorteilhaft, den wobbelnden Feidspiegel so dicht wie möglich an der Retikelebene anzubringen.

Nachfolgend soll eine Abschätzung für den zu variierenden Winkelbereich des wobbelnden Feldspiegels bzw. periodisch sich bewegenden Feldspiegels gegeben werden: Nimmt man für die Apertur in der Retikelebene $NA_{Ret} = 0{,}025$ an und beträgt der Abstand der Teilpupillen aufgrund der Parzellierung bei $_\Delta NA \approx 0{,}005$, so sollte der variierende Winkelbereich in der Größenordnung $\approx \pm 2{,}5$ mrad liegen. Ein Beispiel für einen wobbelnden Feldspiegel wäre ein Toroidspiegel mit einer Größe von 160 x 170 mm sowie einem lokalen dynamischen Gradienten von $\pm 2$ mrad in x- und y-Richtung bei der Stabilität von $\pm 0.1$ mrad.

Ein Verschmieren kann nicht nur mit Hilfe von beweglichen sogenannten wobbelnden Feldspiegeln, sondern auch durch dynamisches Verformen der Spiegeloberfläche erreicht werden.

Um eine hohe Scan-Uniformity zu erzielen, kann mit Vorteil die Verwendung von aktiven Linsen oder Spiegeln für die optischen Elemente vorgesehen sein.

Da die Fertigung von Feldwaben mit einem hohen Aspektverhältnis von beispielsweise 20 : 1 schwierig ist, kann mit Vorteil vorgesehen sein, zur Reduzierung des Aspektverhältnisses der Feldwaben diese astigmatisch auszubilden. Dabei werden die sekundären Lichtquellen in tangentiale und sagittale sekundäre Lichtquellen aufgespalten, die sich in der tangentialen und sagittalen Blendenebene befinden.

Während das System bei Wellenlängen im EUV-Bereich, wie zuvor beschrieben, rein reflektiv, d.h. ausschließlich mit Spiegelkomponenten designt ist, ist eine Verwendung auch bei 193 nm bzw. 157 nm-System denkbar. In einem solchen Fall kommen refraktive Komponenten wie Linsen zum Einsatz.

Die hierin beschriebenen Systeme sind insbesondere deswegen für 193 nm- bzw. 157 nm-Systeme von Interesse, weil sie mit wenigen optischen Komponenten auskommen und die optischen Elemente bei diesen Wellenlängen hohe Absorptionen aufweisen.

Vorteilhafte Ausgestaltung der Erfindung sind Gegenstand der Unteransprüche.

Nachfolgend soll die Erfindung anhand der Zeichnungen beispielhaft beschrieben werden.

Es zeigen:

Fig. 1:       Prinzipskizze des Strahlengangs eines Systems mit zwei Wabenplatten;
Fig. 2A, 2B:       Feld- und Pupillen-Abbildung für das zentrale Wabenpaar;
Fig. 3:       Verlauf der Lichtstrahlen für eine Rechteckfeldwabe in Kombination mit einer Rechteckpupillenwabe;
Fig. 4:       Verlauf gemäß Fig. 3 mit in den Strahlverlauf eingebrachter Feldlinse;
Fig. 5:       Verlauf gemäß Fig. 3 mit zwei in den Strahlverlauf eingebrachten Feldlinsen;
Fig. 6:       Prinzipskizze für ein refraktives System mit Feld- und Pupillenwaben;

Fig. 7-14: unterschiedliche Anordnungen von Feldwaben auf einer Feldwabenplatte;

Fig. 15-17: Gitter von sekundären Lichtquellen in der Eintrittspupille des Objektives;

Fig. 18-20: Zusammenhang zwischen ausgeleuchteten Flächen von Pupillenwabenplatte und Feldwabenplatte sowie Baulänge und Apertur in der Retikelebene;

Fig. 21A-21B: eine erste Ausführungsform eines Beleuchtungssystems mit Undulator-Lichtquelle (Typ A) in refraktiver Darstellung;

Fig. 22A-22B: eine zweite Ausführungsform eines Beleuchtungssystems mit Undulator-Lichtquelle (Typ B) in refraktiver Darstellung;

Fig.23A-23B: eine dritte Ausführungsform eines Beleuchtungssystems mit Undulator-Lichtquelle (Typ C) in refraktiver Darstellung;

Figur 24: prinzipielle Anordnung eines Typ A-Beleuchtungssystems in reflektiver Darstellung;

Figur 25: Anordnung der Rasterelemente auf dem facettierten ersten Spiegel;

Fig. 26 - 29: eine Ausgestaltung eines Typ-A-Beleuchtungssystems;

Fig. 30 - 33: Ausleuchtung, Intensitätsverlauf, Scanenergie und Pupillenausleuchtung eines Systems gemäß der Figuren 26 bis 29;

Fig. 34 - 37: eine Ausgestaltung eines Typ-B-Beleuchtungssystems;

Fig. 38 - 41: Ausleuchtung, Intensitätsverlauf, Scan-Energie und Pupillenausleuchtung eines Systems gemäß Figuren 34 bis 37;

Fig. 42 - 43: prinzipielle Anordnung eines Typ C1-Beleuchtungssystems in reflektiver Darstellung;

Figur 44: prinzipielle Anordnung eines Typ C2-Beleuchtungssystems in reflektiver Darstellung;

Fig. 45 - 50: eine Ausgestaltung eines Typ C1-Beleuchtungssystems;

Fig. 51 - 54: Ausleuchtung, Intensitätsverlauf, Scan-Energie und Pupillenausleuchtung eines Systems gemäß den Figuren 45 bis 50;

Fig. 55A-55B: eine Ausgestaltung der Erfindung mit virtueller Blendenebene.

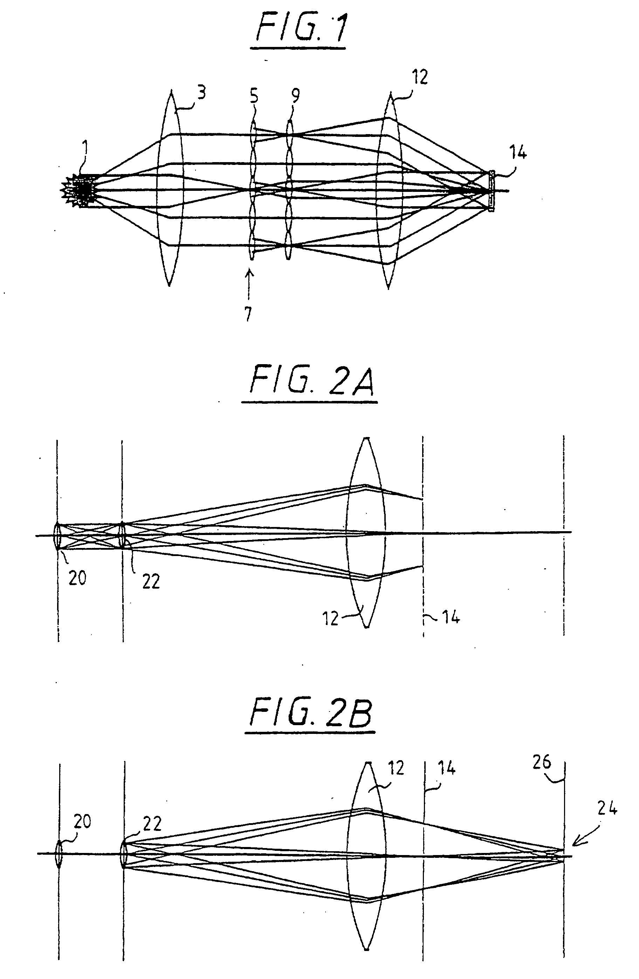

Anhand der Fig. 1-20 soll zunächst theoretisch dargestellt werden, wie mit Hilfe der erfindungsgemäßen Beleuchtungseinrichtung für beliebige Beleuchtungsverteilungen A in einer Ebene ein System angegeben werden kann, das den Anforderungen in bezug auf Uniformität und Telezentrie genügt Das dargestellte System ist ein System mit Feldwaben- und Pupillenwabenplatte.

In Figur 1 ist eine Prinzipskizze des Strahlengangs eines refraktiven Systemes mit zwei Wabenplatten abgebildet. Das Licht der Quelle 1 wird mit Hilfe einer Kollektorlinse 3 gesammelt und in ein paralleles oder konvergentes Lichtbüschel umgewandelt. Die Feldwaben 5 der ersten Wabenplatte 7 zerlegen die Lichtbüschel und erzeugen am Ort der Pupillenwaben 9 sekundäre Lichtquellen. Die Feldlinse 12 bildet diese sekundären Lichtquellen in die Austrittspupille des Beleuchtungssystems bzw. die Eintrittspupille des nachfolgenden Objektives ab. Eine derartige Anordnung zeichnet sich durch einen verflochtenen Strahlengang von Feld- und Pupillenebene von der Quelle bis zur Eintrittspupille des Objektivs aus. Hierfür wird oft auch die Bezeichnung "Köhlersche Beleuchtung" gewählt, wie beispielsweise in der US 5,677, 939 definiert, deren Offenbarungsgehalt vollumfänglich in vorliegende Anmeldung mitaufgenommen wird.

Nachfolgend wird das Beleuchtungssystem gemäß Fig. 1 abschnittsweise betrachtet. Da die Schnittstelle die Licht- und Aperturverteilung in der Ebene der Feldwaben ist, kann die Betrachtung unabhängig von der Quellenart und dem Kollektorspiegel erfolgen.

In Fig. 2A und 2B ist für das zentrale Wabenpaar 20, 22 die Feld- und Pupillen-Abbildung eingezeichnet. Mit Hilfe der Pupillenwabe 22 und der Feldlinse 12 wird die Feldwabe 20 auf das Retikel 14 bzw. die abzubildende Maske abgebildet. Die geometrische Ausdehnung der Feldwabe 20 bestimmt die Form des ausgeleuchteten Feldes in der Retikelebene 14. Der Abbildungsmaßstab ist näherungsweise durch das Verhältnis der Abstände Pupillenwabe 22 - Retikel 14 und Feldwabe 20 - Pupillenwabe 22 gegeben. Die optische Wirkung der Feldwabe 20 ist so ausgelegt, daß am Ort der Pupillenwabe 22 ein Bild der Lichtquelle 1 entsteht, eine sekundäre Lichtquelle. Ist die Ausdehnung der Lichtquelle gering, beispielsweise näherungsweise punktförmig, so verlaufen alle Lichtstrahlen durch die optische Mitte der Pupillenwabe 22. In einem solchen Fall ist eine Beleuchtungseinrichtung realisierbar, bei der auf die Pupillenwabe verzichtet wird.

Wie in Fig. 2 B gezeigt, besteht die Aufgabe der Feldlinse 12 darin, die sekundären Lichtquellen in die Eintrittspupille 26 des Objektivs 24 abzubilden. Bringt man in den Strahlengang eine Feldlinse ein, so kann die Feldabbildung in der Weise beeinflußt werden, daß durch Steuerung der Verzeichnung das Bild der Feldwabe verformt wird. Denkbar ist, ein Rechteck in ein Ringsegment zu verformen. Der Abbildungsmaßstab der Feldwabenabbildung wird dadurch nicht verändert.

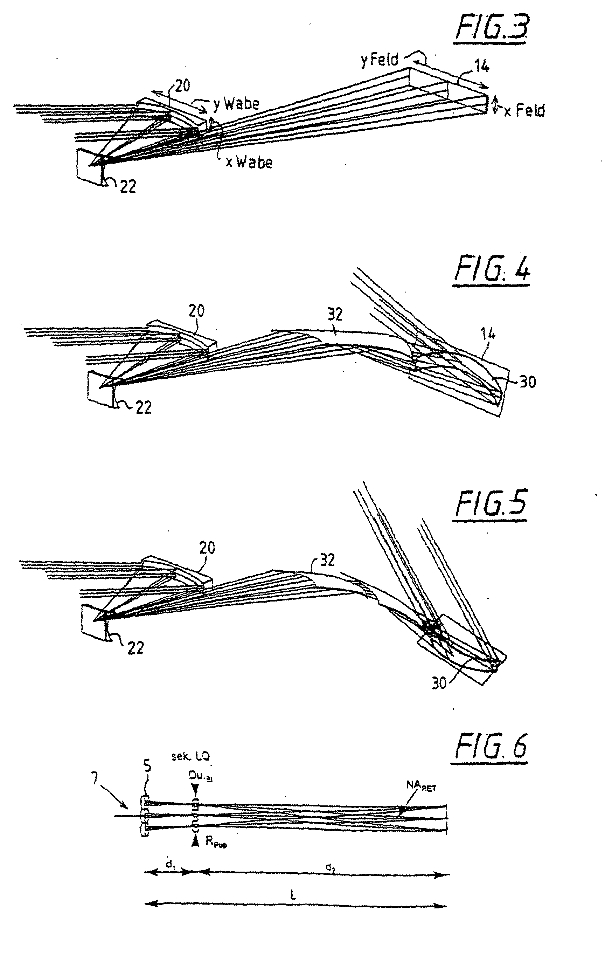

In Figur 3 ist für eine spezielle geometrische Form einer Feldwabe und einer Pupillenwabe der Verlauf der Lichtstrahlen dargestellt.

In der in Figur 3 dargestellten Ausführungsform ist die Form der Feldwaben 20 rechteckig gewählt. Dabei entspricht das Aspektverhältnis der Feldwaben 20 dem Verhältnis von Bogenlänge zu Ringbreite des geforderten Ringfeldes in der Retikelebene. Das Ringfeld wird, wie in Fig. 4 dargestellt, durch die Feldlinse geformt. Ohne Feldlinse ergibt sich, wie in Fig. 3 gezeigt, in der Retikelebene ein Rechteckfeld.

Zur Formung des Ringfeldes 30 wird, wie in Fig. 4 dargestellt, eine grazingincidence-Feldspiegel 32 verwandt. Unter der Nebenbedingung, daß die vom Retikel reflektierte Strahlung nicht mehr ins Beleuchtungssystem zurücklaufen darf, sind je nach Lage der Eintrittspupille des Objektivs ein oder zwei Feldspiegel 32 erforderlich.

Laufen die Hauptstrahlen divergent ins nicht dargestellte Objektiv, so genügt ein Feldspiegel 32, wie in Figur 4 dargestellt. Bei konvergentem Hauptstrahlverlauf benötigt man zwei Feldspiegel. Der zweite Feldspiegel muß die Orientierung des Ringes umdrehen. Eine derartige Konfiguration ist in Figur 5 gezeigt.

Bei einem Beleuchtungssystem im EUV-Wellenlängenbereich müssen alle Komponenten reflektiv ausgebildet werden.

Wegen der hohen Reflektionsverluste bei $\lambda$ = 10 nm - 14 nm ist es vorteilhaft, daß die Zahl der Reflektionen so gering wie möglich gehalten werden.

Beim Aufbau des reflektiven Systems muß die gegenseitige Vignettierung der Strahlen berücksichtigt werden. Dies kann durch Aufbau des Systemes im Zick-Zack-Strahlengang erfolgen oder durch Arbeiten mit Obskurationen.

Nachfolgend soll das erfindungsgemäße Verfahren zum Erstellen eines Designs für ein EUV-Beleuchtungssystem bei beliebiger Ausleuchtung in einer Ebene A beispielhaft beschrieben werden.

Die für das erfindungsgemäße Verfahren erforderlichen Definitionen sind in Fig. 6 gezeigt.

Zunächst wird der Strahlengang für das zentrale Wabenpaar berechnet.

In einem ersten Schritt wird die Größe der Feldwaben 5 der Feldwabenplatte 7 bestimmt werden. Wie zuvor aufgezeigt, ergibt sich für Rechteckwaben das Aspektverhältnis (x/y) aus der Form des Ringfeldes in der Retikelebene. Die Größe der Feldwaben wird bestimmt durch die Ausdehnung A der Intensitätsverteilung der beliebigen Lichtquelle in der Ebene der Feldwaben und der Anzahl N der Feldwaben auf der Wabenplatte, die wiederum durch die Zahl der sekundären Lichtquellen gegeben ist. Die Anzahl der sekundären Lichtquellen ergibt sich wiederum aus der Gleichmäßigkeit der Pupillenausleuchtung sowie der Durchmischung.

Die Wabenfläche $A_{Wabe}$ einer Feldwabe mit $x_{Wabe}$, $y_{Wabe}$ kann wie folgt ausgedrückt werden:

$$A_{Wabe} = x_{Wabe} \cdot y_{Wabe} = (x_{Feld} / y_{Feld}) \, y_{Wabe}^2$$

wobei $x_{Feld}$, $y_{Feld}$ die Größe des Rechteckes, das das Ringfeld festlegt, beschreibt. Weiter gilt für die Anzahl N der Feldwaben:

$$N = \frac{A}{A_{Wabe}} = \frac{A}{y_{Wabe}^2 \, (x_{Feld} / y_{Feld})}$$

Hieraus folgt für die Größe der einzelnen Feldwabe:

$$y_{Wabe} = \sqrt{\frac{A}{N \cdot (x_{Feld} / y_{Feld})}}$$

und

$$\frac{x_{Wabe}}{y_{Wabe}} = \frac{x_{Feld}}{y_{Feld}}$$

Die Wabengröße und die Größe des Rechteckfeldes legen den Abbildungsmaßstab $\beta_{Wabe}$ der Wabenabbildung fest und damit das Verhältnis der Abstände $d_1$ und $d_2$.

$$\beta_{Wabe} = \frac{x_{Feld}}{y_{Feld}} = \frac{d_2}{d_1}$$

Die vorgegebene Baulänge L für das Beleuchtungssystem und der Wabenabbildungsmaßstab $\beta_{Wabe}$ bestimmen die absolute Größe von $d_1$ und $d_2$ und damit die Lage der Pupillenwabenplatte. Es gilt:

$$d_1 = \frac{L}{1 + \beta_{Wabe}}$$

$$d_2 = d_1 \cdot \beta_{Wabe}$$

$d_1$ und $d_2$ bestimmen wiederum den Radius der Pupillenwaben.

Es gilt:

$$R_{Pup} = \frac{2 \cdot d_1 \cdot d_2}{d_1 + d_2}$$

Um die Pupillenwaben in die Eintrittspupille des Objektives abzubilden und das Rechteckfeld in ein Ringfeld umzuformen, werden zwischen Pupillenwabe und Retikel eine oder mehrere Feldlinsen, vorzugsweise in Toroidform, eingebracht. Durch die Einführung der Feldspiegel wird die vorgegebene Baulänge vergrößert, da unter anderem die Spiegel Mindestabstände einhalten müssen, um Vignettierungen zu vermeiden.

Die Positionierung der Feldwaben hängt von der Intensitätsverteilung in der Ebene der Feldwaben ab. Die Zahl N der Feldwaben ist durch die Zahl der sekundären Lichtquellen vorgegeben. Die Feldwaben werden vorzugsweise derart auf der Feldwabenplatte angeordnet, daß sie die ausgeleuchtete Fläche, ohne sich gegenseitig zu vignettieren, abdecken.

Zur Positionierung der Pupillenwaben wird in der Eintrittspupille des Objektivs die Rasterung der sekundären Lichtquellen vorgegeben. Die sekundären Lichtquellen werden entgegen der Lichtrichtung durch die Feldlinse abgebildet. Die Blendenebene dieser Abbildung befindet sich in der Retikelebene. Die Bilder der sekundären Lichtquellen geben die (x, y, z)-Position der Pupillenwaben an. Als Freiheitsgrad für die Herstellung des Lichtweges zwischen Feld- und Pupillenwabe verbleibt der Kipp- und Drehwinkel.

Wird in einer Ausgestaltung der Erfindung jeder Feldwabe eine Pupillenwabe zugeordnet, so wird der Lichtweg durch Kippung und Drehung von Feld- und Pupillenwabe hergestellt. Hierbei werden die Strahlbüschel so umgelenkt, daß die Mittenstrahlen alle in der Retikelebene die optische Achse schneiden.

Die Zuordnung von Feld- und Pupillenwaben ist frei. Eine Möglichkeit der Zuordnung wäre, jeweils räumlich benachbarte Waben einander zuzuordnen. Dadurch werden die Umlenkwinkel minimal. Eine andere Möglichkeit besteht darin, die Intensitätsverteilung in der Pupillenebene auszugleichen. Dies kommt beispielsweise dann zum Tragen, wenn die Intensitätsverteilung in der Ebene der Feldwaben einen Verlauf aufweist. Haben Feld- und Pupillenwaben ähnliche Positionen, überträgt sich der Verlauf auf die Pupillenausleuchtung. Durch gezielte Durchmischung der Zuordnung kann die Intensität ausgeglichen werden.

Vorteilhafterweise werden die Einzelkomponenten Feldwabenplatte, Pupillenwabenplatte und Feldspiegel des Beleuchtungssystems im Strahlengang derart angeordnet, daß ein vignettierungsfreier Strahlenverlauf möglich ist. Hat eine derartige Anordnung Auswirkungen auf die Abbildung, so müssen die einzelnen Lichtkanäle und die Feldlinse nachoptimiert werden.

Mit dem zuvor beschriebenen Design-Verfahren können für beliebige Ausleuchtungen A mit zwei normal-incidence und ein bis zwei grazingincidence-Reflektionen Beleuchtungssysteme für die EUV-Lithographie erhalten werden, die folgende Eigenschaften aufweisen:

- eine homogene Ausleuchtung beispielsweise eines Ringfeldes
- eine homogene und feldunabhängige Pupillenausleuchtung
- das Zusammenlegen von Austrittspupille des Beleuchtungssystems und Eintrittspupille des Objektivs
- das Einstellen einer vorgegebenen Baulänge
- die Aufnahme des maximal möglichen Lichtleitwertes.

Nachfolgend sollen für eine Ausführungsform der Erfindung mit Feld- und Pupillenwabenplatte Anordnungen von Feldwaben und Pupillenwaben beschrieben werden.

Zunächst werden unterschiedliche Anordnungen der Feldwaben auf der Feldwabenplatte betrachtet. Hierbei kann die Intensitätsverteilung beliebig sein.

Die angeführten Beispiele beschränken sich auf einfache geometrische Formen, wie Kreis, Rechteck, die Kopplung mehrerer Kreise bzw Rechtecke. Innerhalb des ausgeleuchteten Bereichs soll die Intensitätverteilung homogen sein oder einen langsam variierenden Verlauf aufweisen. Die Aperturverteilung soll unabhängig vom Feld sein.

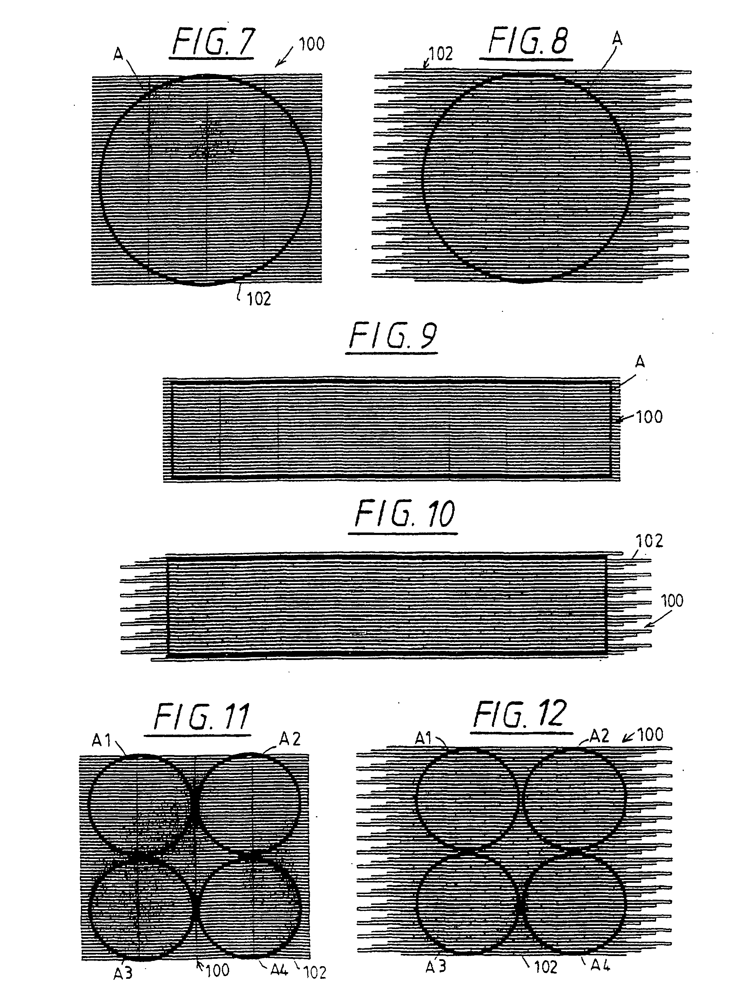

Bei kreisförmiger Ausleuchtung A der Feldwabenplatte 100 können die Feldwaben 102 zum Beispiel in Spalten und Zeilen angeordnet sein, wie in Figur 7 dargestellt. Alternativ hierzu können die Aufpunkte der Waben gleichmäßig durch Verschieben der Zeilen über die Fläche verteilt sein, wie in Figur 8 dargestellt. Letztere Anordnung ist besser an eine gleichmäßige Verteilung der sekundären Lichtquellen angepaßt.

Eine rechteckige Ausleuchtung A ist in Figur 9 dargestellt. Eine Verschiebung der Zeilen, wie in Figur 10 dargestellt, führt zu einer gleichmäßigeren Verteilung der sekundären Lichtquellen. Diese sind jedoch entsprechend der Ausdehnung der Feldwabenplatte innerhalb eines Rechtecks angeordnet. Um dennoch die sekundären Lichtquellen in der kreisrunden Blendenebene verteilen zu können, wird eine Doppelfacettierung vorgesehen. Die Pupillenwaben sitzen am Ort der sekundären Lichtquellen. Bei rechteckiger Ausleuchtung ist es erforderlich, zur Herstellung des Lichtweges zwischen Feld- und Pupillenwaben die Feldwaben so zu kippen, daß die Strahlbüschel auf die beispielsweise innerhalb eines Kreises angeordneten Pupillenwaben treffen, die ebenfalls gekippt werden müssen.

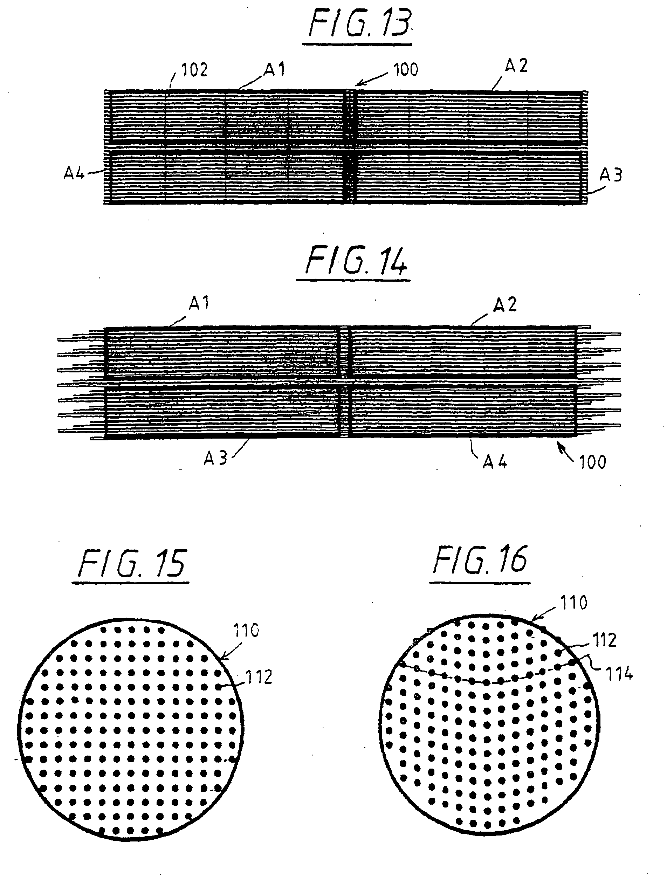

Setzt man die Ausleuchtung A der Feldwabenplatte 100 aus mehreren Kreisen A1, A2, A3, A4 zusammen, beispielsweise durch Kopplung von verschiedenen Strahlengängen einer oder mehrerer Quellen, so ist bei gleichbleibender Wabengröße die Durchmischung bei einer Anordnung der Waben in Zeilen und Spalten gemäß Figur 11 unzureichend. Eine gleichmäßigere Beleuchtung erhält man durch die Verschiebung der Wabenzeilen, wie in Figur 12 dargestellt.

Die Figuren 13 und 14 zeigen die Verteilung der Feldwaben 102 bei zusammengesetzter Ausleuchtung aus Einzelrechtecken A1, A2, A3, A4.

Nunmehr sollen beispielhafte Anordnungen der Pupillenwaben auf der Pupillenwabenplatte beschrieben werden.

Bei der Anordnung der Pupillenwaben sind zwei Gesichtspunkte zu berücksichtigen:

1. Für die Minimierung der Kippwinkel von Feld- und Pupillenwaben zur Herstellung des Lichtweges ist es vorteilhaft, sich an die Anordnung der Feldwaben zu halten. Dies ist insbesondere bei näherungsweise kreisförmiger Ausleuchtung der Feldwabenplatte vorteilhaft.

2. Zur homogenen Pupillenfüllung sollen die sekundären Lichtquellen in der Eintrittspupille des Objektivs gleichmäßig verteilt sein. Dies kann erreicht werden, indem man in der Eintrittspupille des Objektivs eine gleichmäßige Rasterung von sekundären Lichtquellen vorgibt. Diese werden entgegen der Lichtrichtung mit der Feldlinse in die Ebene der Pupillenwaben abgebildet und bestimmen dadurch den idealen Ort der Pupillenwaben.

Ist die Feldlinse verzeichnungsfrei, so entspricht die Verteilung der Pupillenwaben der Verteilung der sekundären Lichtquellen. Da die Feldlinse jedoch das Ringfeld formt, wird gezielt Verzeichnung eingeführt. Dabei handelt es sich nicht um rotationssymmetrische kissen- oder tonnenförmige Verzeichnung, sondern um die Verbiegung von horizontalen Linien zu Bögen. Der y-Abstand der Bögen bleibt im Idealfall konstant. Reale grazing-incidence-Feldspiegel zeigen jedoch auch eine zusätzliche Verzeichnung in y-Richtung.

In Figur 15 ist ein Gitter 110 von sekundären Lichtquellen 112 in der Eintrittspupille des Objektivs, die zugleich Austrittspupille des Beleuchtungssystems ist, gezeigt, wie es sich für verzeichnungsfreie Abbildung ergeben würde. Die Anordnung der sekundären Lichtquellen 112 entspricht genau der vorgegebenen Anordnung der Pupillenwaben.

Werden wie in Figur 16 die Feldlinsen zur Ringfeldformung eingesetzt, so liegen die sekundären Lichtquellen 112 auf Bögen 114.

Legt man die Pupillenwaben einzelner Zeilen auf Bögen, die die Verzeichnung vorhalten, so kann man die sekundären Lichtquellen wieder auf ein regelmäßiges Gitter legen.

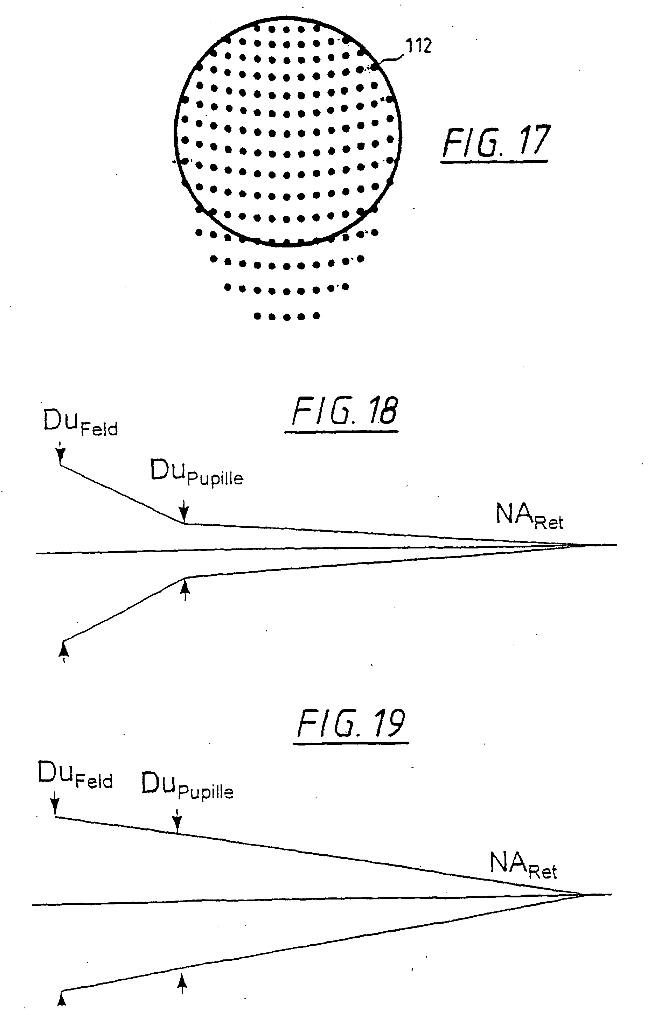

Führt die Feldlinse zusätzlich Verzeichnung in y-Richtung ein, so wird die Pupille in y-Richtung verzerrt, wie in Figur 17 gezeigt.

Die Ausdehnung der ausgeleuchteten Fläche auf der Feldwabenplatte ist mit der Definition der Eingangsbeleuchtung vorgegeben. Die Ausleuchtung der Pupillenwabenplatte ist durch die Baulänge und die Apertur in der Retikelebene bestimmt.

Wie zuvor eingehend beschrieben, müssen durch Dreh und Kipp von Feld- und Pupillenwaben die beiden Flächen aufeinander abgestimmt werden.

Zur Veranschaulichung wird die Problematik an linear aufgezogenen Prinzipskizzen erläutert. Die Beispiele lassen sich jedoch direkt auf reflektive Systeme übertragen. Für eine kreisförmige Ausleuchtung der Feldwabenplatte sind verschiedene Fälle zu unterscheiden, wie nachfolgend dargestellt.

Wird durch Kipp der Feldwaben eine sammelnde Wirkung, durch Kipp der Pupillenwaben eine zerstreuende Wirkung eingeführt, so kann der Büschelquerschnitt verringert werden. Die Kippwinkel der einzelnen Waben werden mit Hilfe der Mittenstrahlen für jedes Wabenpaar bestimmt. Für die Mittenstrahlen wirkt das System wie ein Tele-System, wie in Figur 18 gezeigt.

Inwieweit die Feldwaben gekippt werden müssen, hängt von der Konvergenz des eintreffenden Strahlbüschels ab. Ist die Konvergenz an die Verringerung des Büschelquerschnitts angepaßt, können die Feldwaben ohne Kippwinkel auf einem Plansubstrat angebracht werden.

Ein Spezialfall ergibt sich, wenn die Konvergenz zwischen Feld- und Pupillenwabenplatte der Apertur am Retikel entspricht, wie in Figur 19 gezeigt.

Muß keine zerstreuende Wirkung durch die Pupillenwaben eingeführt werden, so können sie ohne Flächenkipp eingesetzt werden. Wenn zudem die Lichtquelle einen sehr kleinen Lichtleitwert besitzt und die sekundären Lichtquellen nahezu punktförmig sind, kann auf die Pupillenwaben vollständig verzichtet werden.

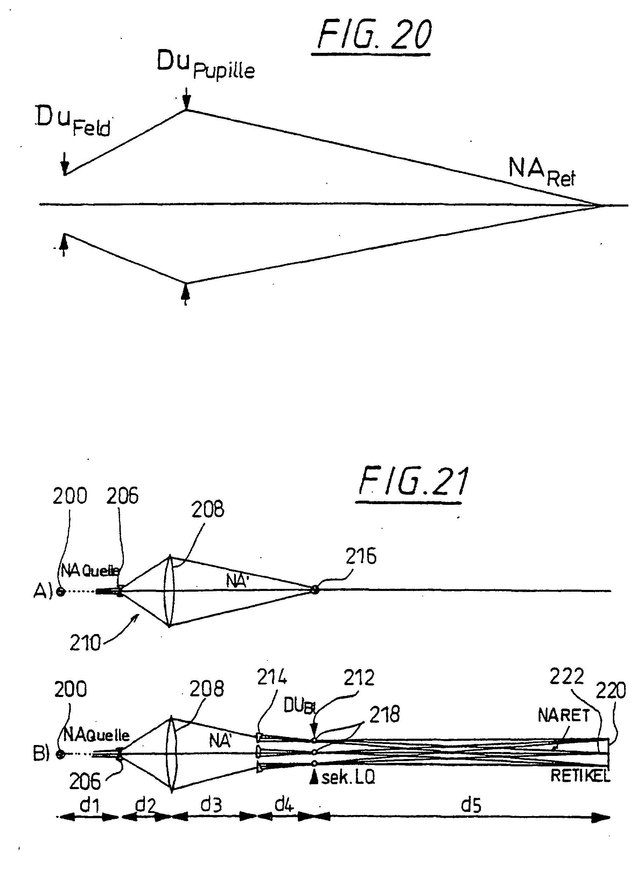

Eine Vergrößerung des Büschelquerschnitts ist möglich, wenn durch Kipp der Feldwaben zerstreuende Wirkung, durch Kipp der Pupillenwaben sammelnde Wirkung eingeführt wird. Für die Mittenstrahlen wirkt das System wie ein Retrofokus-System, wie in Figur 20 gezeigt.

Entspricht die Divergenz der eintreffenden Strahlung der Büschelvergrößerung zwischen Feld- und Pupillenwaben, so können die Feldwaben ohne Flächenkipp verwendet werden.

Anstelle der beschriebenen runden Form sind auch rechteckige oder andere Formen der Ausleuchtung A der Feldwabenplatten möglich.

Die in den nachfolgend beschriebenen Figuren 21A-56 gezeigten Anordnungen zeigen Ausführungsformen der Erfindung bei der als Synchrotron-Strahlungslichtquellen Undulatoren verwendet werden, ohne daß die Erfindung hierauf beschränkt ist.

Die Strahlung der Undulator-Lichtquelle läßt sich auf eine Punktlichtquelle mit stark gerichteter Strahlung, beispielsweise beträgt die Divergenz sowohl in horizontaler wie vertikaler Richtung weniger als 10 mrad, zurückführen, weswegen alle nachfolgend beispielhaft beschriebenen Beleuchtungssysteme nur einen Spiegel bzw. eine Linse mit Rasterelementen aufweisen, ohne daß die Erfindung hierauf beschränkt ist.

Undulator-Quellen weisen in der ausgezeichneten Ebene in die das vorbestimmte Wellenlängenspektrum abgestrahlt wird, eine Strahldivergenz < 100 mrad, vorzugsweise < 50 mrad auf, weswegen Kollektoren entlang der Elektronenbahn zum Sammeln der Synchrotron-Strahlung und Bündeln derselben, wie beispielsweise in der US-A-5439781 oder US-A-5512759 für derartige Quellen beschrieben, nicht benötigt werden.

Nachfolgend sollen drei mögliche Ausgestaltungen eines Beleuchtungssystems mit Undulator-Quelle 200 und einem Spiegel mit Rasterelementen beschrieben werden.

Es bezeichnet:

Typ A     eine Ausführungsform, bei der die einzelnen Rasteretemente des ersten Spiegels einzelne gekippte Planfacetten sind.

Typ B     eine Ausführungsform, bei der die einzelnen Rasterelemente als Facetten im konvergenten Strahlengang ausgeführt sind.

Typ C     eine Ausführungsform, bei der die Rasterelemente des ersten Spiegels mit den Strahlaufweitungsmitteln eine Baueinheit ausbilden.

In den Figuren 21A und 21B ist ein Beleuchtungssystem gemäß Typ A in einer refraktiven Ausführungsform zur Definition der Parameter dargestellt. Bei der Ausführungsform gemäß Typ A umfassen die Mittel zur Strahlaufweitung eine Zerstreulinse 206 bzw. Zerstreuspiegel ohne hierauf beschränkt zu sein.

Die sammelnde Wirkung zur Erzeugung der sekundären Lichtquellen wird durch den der Zerstreulinse bzw. dem Zerstreuspiegel 206 nachgeordneten Sammelspiegel bzw. Sammellinse 208 aufgebracht. Die Mittel zur Strahlaufweitung und der Spiegel bzw. die Linse mit sammelnder Wirkung bilden eine sogenannte Kollektoreinheit bzw. ein Kollektorsystem 210 aus. Ohne Spiegel mit Rasterelementen würde der Sammelspiegel die Quelle 200 in die Blendenebene 2.12 des Beleuchtungssystems abbilden. Mit dem Spiegel mit Rasterelementen 214 bzw. dem Facettenspiegel wird die sekundäre Lichtquelle 216 in eine Vielzahl von sekundären Lichtquellen 218 zerlegt.

Die Rasterelemente 214 können als Planfacetten ausgebildet werden, da die sekundäre Lichtquelle bzw. Lichtquellen in dieser Ausführungsform mit Hilfe der Kollektoreinheit in die Blendenebene abgebildet wird.

Die Kippwinkel der Planfacetten werden so eingestellt, daß die Mittenstrahlen jeder Facette in der Bildebene 220 auf der optischen Achse 222 zusammentreffen. Für die Mittenstrahlen wirkt der Facettenspiegel bzw. -linse wie ein zerstreuender Spiegel bzw. Linse. Zur Veranschaulichung zeigen die , Figuren 21A und 21B den schematischen Aufbau anhand eines refraktiven, linear aufgebauten Systems. In Figur 21A wurde die Facettenlinse entfernt. Die sekundäre Lichtquelle 216 liegt in der Blendenebene. In Figur 21B ist die Facettenlinse 214 eingefügt. Dem Kipp der Facetten entspricht in der refraktiven Darstellung die Anordnung einzelner Prismen.

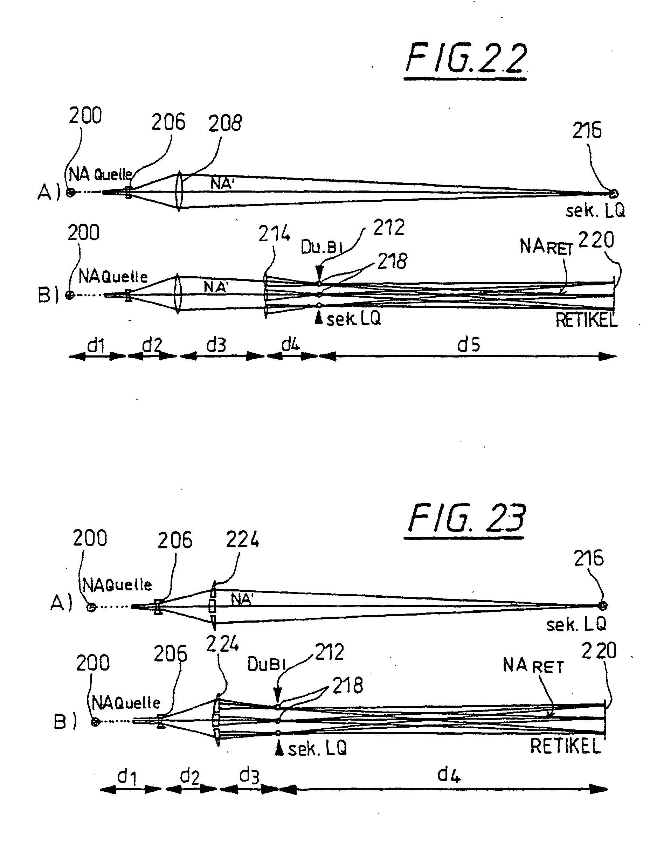

Möglich ist auch die Anordnung des Facettenspiegels bzw. -linse im konvergenten Strahlengang gemäß Typ B wie in den Figuren 22A und 22B gezeigt. Der Sammelspiegel 208 wird dabei so ausgelegt, daß die Quelle 200 in die Bildebene 220 des Beleuchtungssystems abgebildet wird, wie in Figur 22A gezeigt. Die sammelnde Wirkung der Facetten 214 wird dann so ausgelegt, daß in der Blendenebene 212 sekundäre Lichtquellen 218 erzeugt werden, wie in Figur 22B dargestellt.

Bei der Ausführung der Erfindung gemäß Typ C werden wie in den Figuren 23A und 23B gezeigt, der Sammelspiegel bzw. -linse und der Facettenspiegel bzw. -linse vereint. Bei einer derartigen Ausgestaltung wird die sammelnde Wirkung des Kollektorspiegels den Facetten als Kipp überlagert. In der schematischen Darstellung in den Figuren 23A und 23B sind die Waben als Überlagerung von Prisma und Sammellinse angedeutet. In der reflektiven Ausführung handelt es sich um gekippte Sammelspiegel 224.

Nachfolgende Formeln beschreiben für die Beleuchtungsanordnung gemäß Typ A - C die Abbildung durch die Rasterelemente:

$$NA_{Ret} = \frac{DU_{BL}/2}{d_5} \qquad\qquad \Rightarrow DU_{BL} = 2 \cdot d_5 \cdot NA_{Ret}$$

$$\frac{DU_{BL}}{x_{Wabe}} \cdot \frac{d_4 + d_5}{d_5} = 4.0 \qquad\qquad \Rightarrow x_{Wabe} = \frac{DU_{BL}}{4.0} \cdot \frac{d_5}{d_4 + d_5}$$

$$\beta_{Wabe} = \frac{x_{Feld}}{x_{Wabe}} = \frac{d_5}{d_4} \qquad\qquad \Rightarrow \beta_{Wabe} = \frac{x_{Feld}}{x_{Wabe}}$$

$$\Rightarrow d_4 = \frac{d_5}{\beta_{Wabe}}$$

Die Vorgaben sind:

$d_5$: Maß für die Baulänge.
$NA_{Ret}$: Apertur in Retikelebene.
Anzahl der Waben in einer Wabenzeile = 4 bei vorliegender Ausführungsform.
Dies ist ein Maß für die Anzahl der sekundären Lichtquellen, der Uniformität des Feldes und der gleichmäßigen Ausleuchtung der Pupille.
$X_{Feld}$: x-Ausdehnung des Feldes
$DU_{BL}$: Ø Blende
$X_{Wabe}$: x-Ausdehnung Wabe
$y_{Wabe}$: y-Ausdehnung Wabe

Werden die in den Figuren 21A bis 23B beispielhaft für refraktive Systeme gezeigten Beleuchtungssysteme für 13 nm-EUV-Strahlung designt, so müssen diese für die 13 nm-Strahlung reflektiv und aufgrund der hohen Reflektionsverluste mit möglichst wenigen Reflektionen umgesetzt werden.

Bei Verwendung einer Undulator-Quelle als Lichtquelle sind zur Ausleuchtung des Spiegels mit Rasterelementen Strahlaufweitungsmittel, die mit einem Sammelspiegel zu einer Kollektoreinheit zusammengefaßt werden können, erforderlich.

Für eine Undulator-Quelle kann die Kollektoreinheit bei 13 nm-Strahlung aus einem ersten grazing incidence Spiegel oder einem Scanspiegel, der die Strahlung aufweitet, und einem zweiten normal incidence Spiegel, der wieder sammelnd auf die Strahlung wirkt, bestehen.

Um zu einem vorteilhaften Design bei 13 nm Wellenlänge zu gelangen, sind aufgrund der höheren Reaktivität grazing incidence Spiegel (R ≈ 80 %) normal incidence Spiegeln (R ≈ 65 %) vorzuziehen.

Vorteilhafterweise sollte der Abstand $d_1$ von der Quelle zum ersten Spiegel mindestens $d_1$ = 3000 mm betragen. Bei einer derartigen Ausführungsform sollte zwischen dem ersten Spiegel und der restlichen Optik für die Strahlenschutzwand ein Freiraum von 2000 mm eingehalten werden.

Alternativ zur Anordnung mit erstem Spiegel vor der Strahlenschutzwand und zweitem Spiegel nach der Strahlenschutzwand kann der erste Spiegel auch erst nach der Strahlenschutzwand mit $d_1$ > 5000 mm angebracht werden. Er kann dann grazing oder normal incidence ausgeführt werden.

Vorteilhafterweise strahlt die Quelle in horizontaler Richtung ab.

Das horizontal liegende Retikel wird unter einem Hauptstrahlwinkel von höchstens 20°, bevorzugt 10°, besonders bevorzugt 5,43°, beleuchtet.

Eine horizontale Anordnung von Retikel und Wafer ist notwendig, um ein Durchbiegen der Optik im Gravitationsfeld zu vermeiden.

Vorteilhafterweise werden zur Feldformung zwei gracing-incidence Feldspiegel verwandt, um das Retikel mit korrekter Ringorientierung zu beleuchten und das Licht separiert vom Beleuchtungssystem ins Objektiv zu lenken.

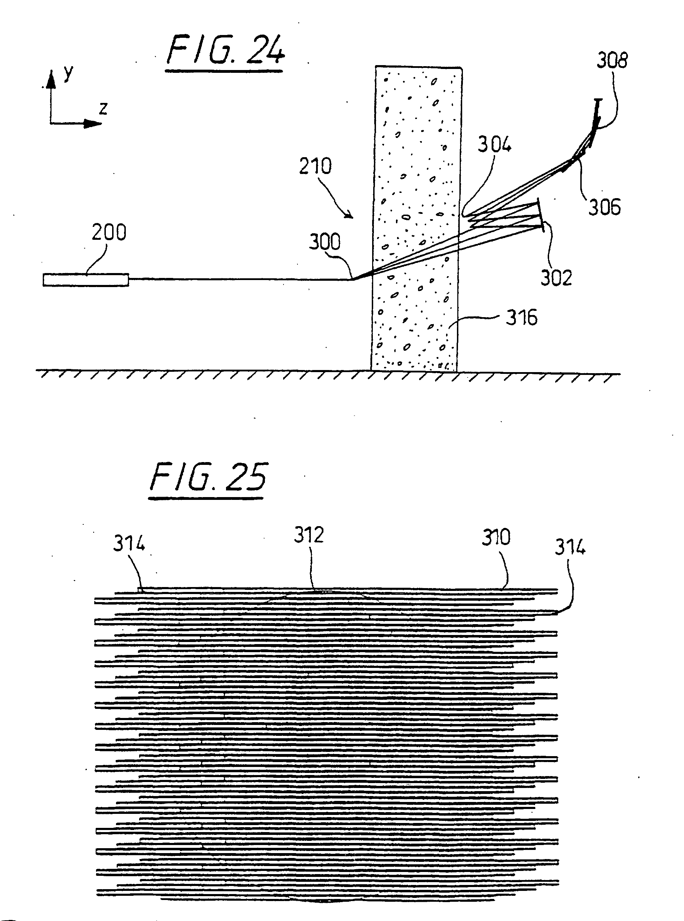

In Figur 24 sind in schematischer Darstellung Beleuchtungssysteme gemäß Typ A und B gezeigt.

Das System gemäß Typ A und B besteht aus einem Kollektorspiegel 300, der als grazing incidence Toroidspiegel, der das Strahlbüschel aufweitet, ausgebildet ist und einem normal incidence Kollektorspiegel 302, der den Spiegel mit Rasterelementen 304 rund ausleuchtet und die Lichtquelle entweder in die Blendenebene (Typ A) oder in die Retikelebene (Typ B) abbildet.

Mit Bezugsziffer 304 ist der normal incidence Facettenspiegel bzw. Spiegel mit Rasterelementen bezeichnet. Die Feldspiegel 306, 308 sind als grazing incidence Feldspiegel ausgebildet und formen das Feld in der Retikelebene.

Die Systemparameter können so ausgelegt werden, daß die optische Achse jeweils nur um die x-Achse gekippt wird (α-Kipp). Die Meridionalebene bleibt dabei erhalten. Die Abstände der Spiegel werden auf die Randbedingungen der Quelle abgestimmt.

Ein derartiges System vom Typ A wird nachfolgend im einzelnen beschrieben.

Als Rasterelemente werden einzeln gekippte Planfacetten verwandt. Die Undulator-Quelle wurde als homogener Flächenstrahler mit Ø 1.0 mm und $NA_{Und}$ = 0.001 angenommen.

Zur gleichmäßigen Verteilung der sekundären Lichtquellen in der Blendenebene wurden die Facettenzeilen 310 versetzt zueinander angeordnet wie in Figur 25 gezeigt. Der Kreis 312 in Fig. 25 zeigt die Ausleuchtung des Spiegels mit Rasterelementen, vorliegend Planfacetten 314 durch die aufgeweitete Undulator-Quelle 200.

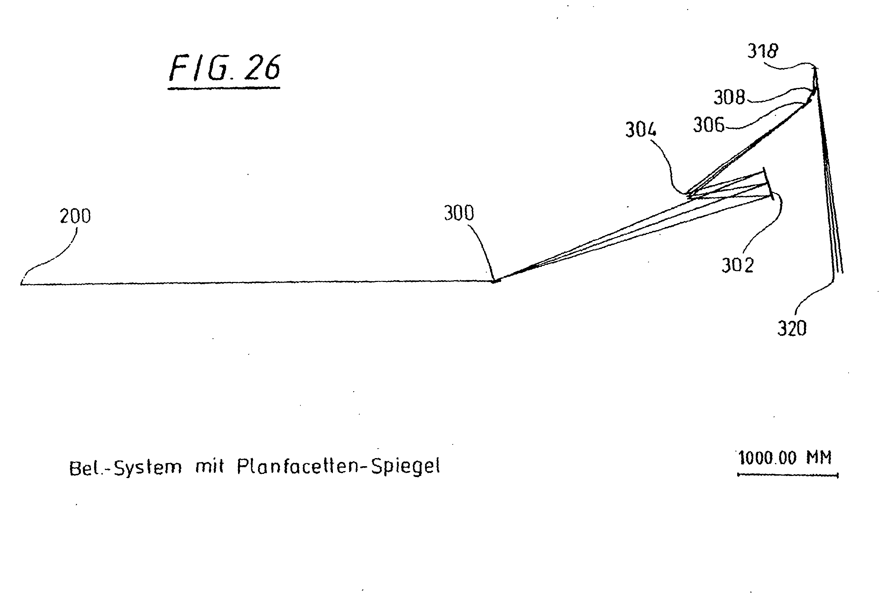

Die Anordnung der Spiegel, bezogen auf das globale Koordinatensystem der Quelle, des in den Figuren 26 bis 33 gezeigten Typ A-Beleuchtungssystems ist in Tabelle Tab. 1 zusammengestellt.

Tab. 1:

| Anordnung der Spiegel für Typ A. | | | | | | | | |
|---|---|---|---|---|---|---|---|---|
| Komponente | X [mm] | Y [mm] | Z [mm] | α [°] | β [°] | γ [°] | AOI [°] | |
| Quelle | 0.000 | 0.000 | 0.000 | 0.000 | 0.000 | 0.000 | 0.000 | - |
| Zerstreuspiegel | 0.000 | 0.000 | 5000.000 | 80.000 | 0.000 | 0.000 | 80.000 | g.i. |
| Sammelspiegel | 0.000 | 1026.060 | 7819.076 | -15.000 | 0.000 | 180.000 | 5.000 | n.i. |
| Spiegel mit Facetten | 0.000 | 878.459 | 6981.991 | 155.000 | 0.000 | 0.000 | 15.000 | n.i. |
| Blende | 0.000 | 1007.017 | 7135.200 | -40.000 | 0.000 | 180.000 | 0.000 | - |
| Feldspiegel 1 | 0.000 | 1906.231 | 8206.842 | 38.858 | 0.000 | 180.000 | 78.858 | g.i. |
| Feldspiegel 2 | 0.000 | 2039.021 | 8276.605 | 16.573 | 0.000 | 0.000 | 78.857 | g.i. |
| Retikel | 0.000 | 2287.899 | 8300.263 | 90.000 | 180.000 | 0.000 | 5.430 | n.i. |
| EP Objektiv | 0.000 | 68.158 | 8511.263 | 90.000 | 0.000 | 0.000 | 0.000 | - |
| X, Y, Z: Koordinatenursprung der Komponenten. α, β, γ : Drehwinkel der Flächen. AOI: Inzidenzwinkel der optischen Achse an den Komponenten. g.i./n.i.: grazing incidence/normal incidence. | | | | | | | | |

Die z-Achse der Retikelebene steht unter 90° zur z-Achse des Quellkoordinatensystems.

Der z-Abstand zwischen Quelle 200 und Kollektorspiegel 300 beträgt bei dem nachfolgend beschriebenen System 5000 mm. Für die Strahlenschutzwand 316 ist ein z-Abstand zwischen Kollektorspiegel 300 und Facettenspiegel 304 von 1900 mm vorgesehen.

Die Retikelebene 318 liegt 2287.9 mm über der Quelle.

Das Design soll nun anhand der Figuren 26 bis 33 beschrieben werden: Figur 26 zeigt das Gesamtsystem bis zur Eintrittspupille 320 des Objektivs im yz-Schnitt umfassend Quelle 200 und Zerstreuspiegel 300, Sammelspiegel 302, Plan-Facettenspiegel 304, Feldspiegel 306, 308, Retikelebene 318 und Eintrittspupille 320 des Objektives. Eingezeichnet sind für die zentrale Feldwabe (0,0) und die beiden äußersten Feldwaben jeweils die Mittenstrahlen. Sie treffen sich in der Retikelebene 318 und leuchten die Eintrittspupille 3320 des Objektivs aus.

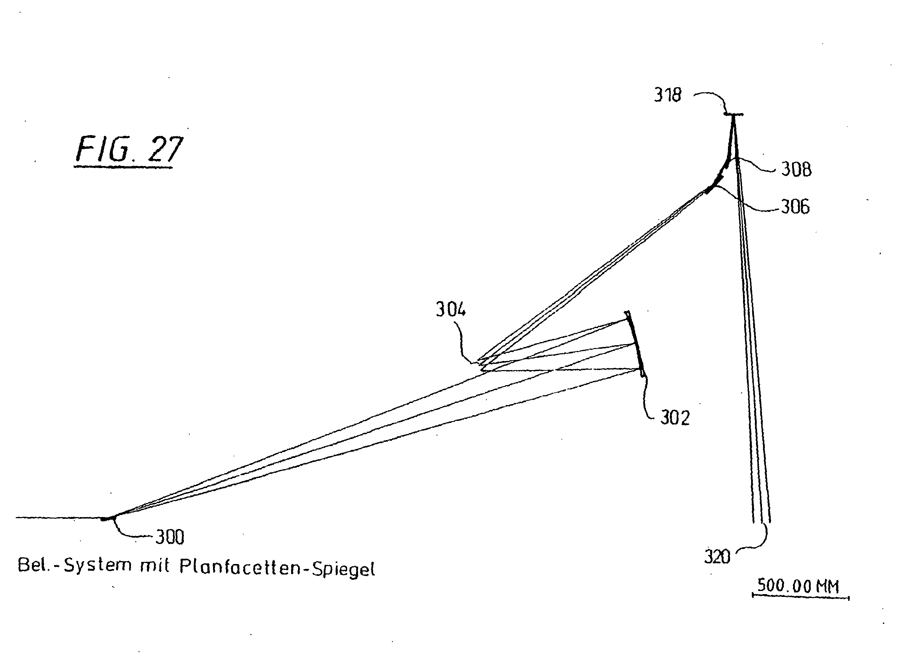

Figur 27 zeigt einen Ausschnitt ab dem Kollektorspiegel. Deutlich zu sehen ist die Strahlumlenkung der Randstrahlen mit den gekippten Facetten.

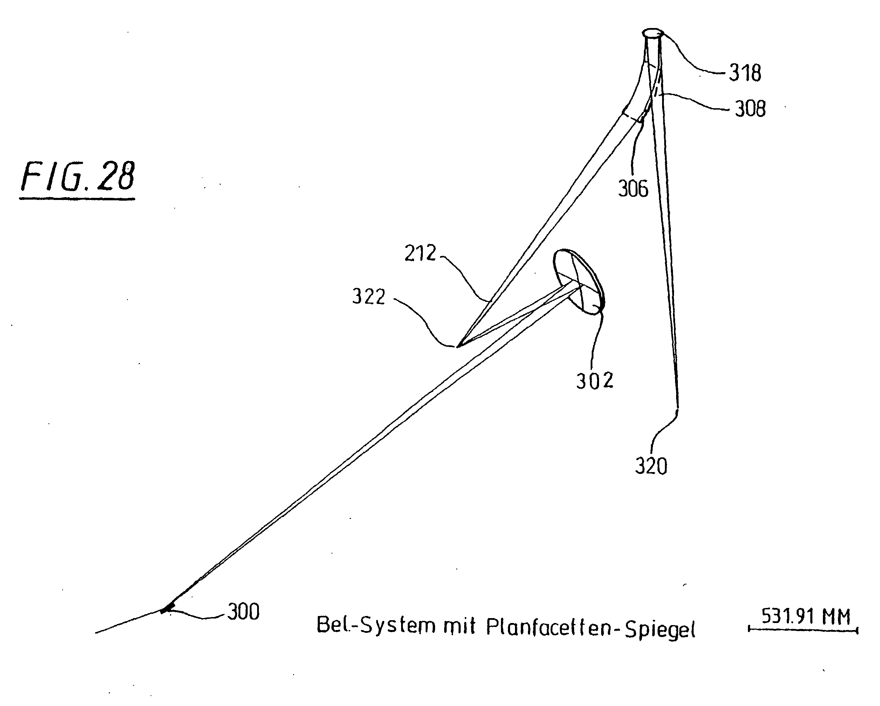

Figur 28 stellt ein Fan von Strahlen, der die zentrale Wabe (0,0) 322 trifft, dar. Der Kollektorspiegel erzeugt in der Blendenebene die sekundäre Lichtquelle 212. Die Feldspiegel formen das Ringfeld und bilden die sekundäre Lichtquelle in die Eintrittspupille des Objektivs ab.

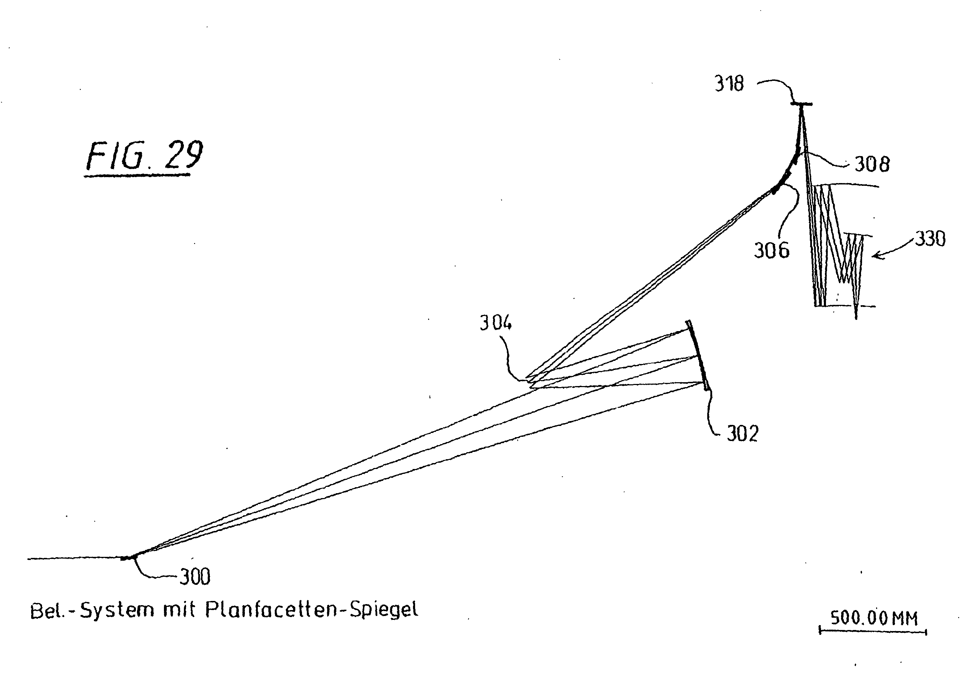

Figur 29 zeigt das Gesamtsystem mit Objektiv im yz-Schnitt umfassend: Zerstreuspiegel 300, Sammelspiegel 302, Plan-Facettenspiegel 304, Feldspiegel 306, 308, Retikelebene 316 und 4-Spiegel-Projektionsobjektiv 330. Das Strahlbüschel läuft getrennt vom Beleuchtungssystem ins Objektiv. Selbstverständlich sind auch andere Projektionsobjektive möglich, beispielsweise 5- oder 6-Spiegel-Objektive.

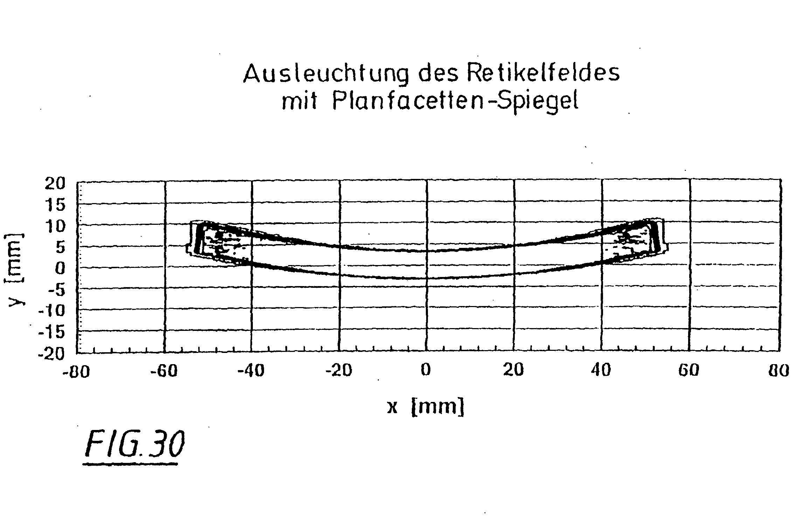

In Figur 30 ist die Ausleuchtung des Retikels mit einem 30°-Ringfeld (r = 211 mm; -3.0 mm, < Δr < +3.0 mm) in Höhenlinien-Darstellung mit einem System gemäß der Figuren 27 bis 29 gezeigt. Hierbei ist r der Ringradius, wobei aus dem Ring ein 30°-Segment verwendet wird.

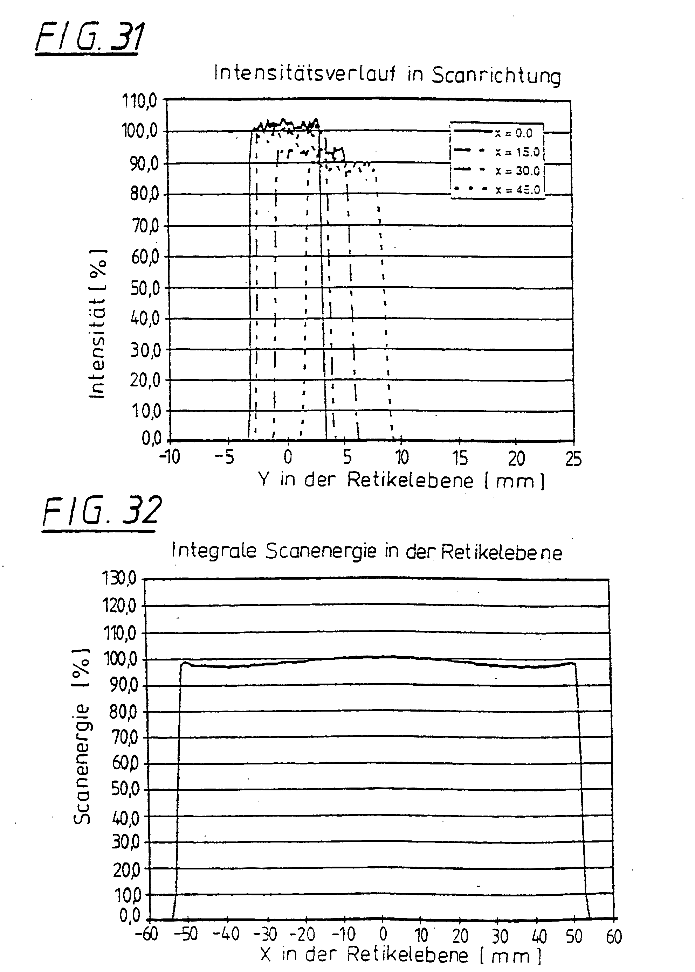

In Figur 31 ist ein Intensitätsschnitt parallel zur y-Achse bei x = 0.0, 15 mm 30 mm, 45 mm dargestellt. Aufgrund der minimalen Ausdehnung der sekundären Lichtquellen entsteht ein ideales "Hut"-Profil. Die Breite der Intensitätsprofile nimmt zum Feldrand hin wegen der Ringkrümmung und der nicht optimalen Überlagerung der Teilbilder zu. Um die Scanenergie konstant zu halten, nimmt die Maximalintensität in gleichem Maße ab. Für den Lithographie-Prozeß entscheidend ist die integrale Scanenergie, d.h. die Integration der Intensität entlang des Scan-Weges. Die integrale Scan-Energie ist, wie in Figur 32 gezeigt, bei vorliegender Ausführungsform nahezu homogen. Sie kann durch das Design der optischen Elemente, wie Feldspiegel oder Feldlinse, gesteuert werden.

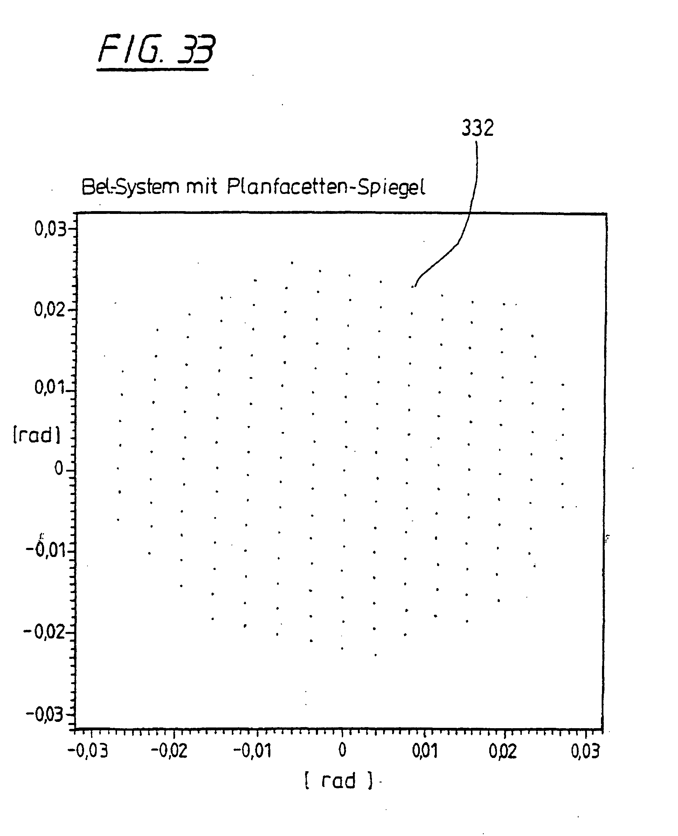

Figur 33 schließlich zeigt die Pupillenausleuchtung in der Feldmitte. Entsprechend der Wabenverteilung ergeben sich Intensitäts-Peaks 332 in der Pupillenausleuchtung. Die maximale Apertur beträgt $NA_{Ret}$ = 0.025. Die Apertur einer Teilpupille ist entsprechend dem kleinen Lichtleitwert der Undulator-Quelle vernachlässigbar klein ($NA_{Teilpupille}$ = 2E-6).

Dennoch ergibt sich integral gesehen durch die gleichmäßige Verteilung der sekundären Lichtquellen eine Füllung der Pupille.

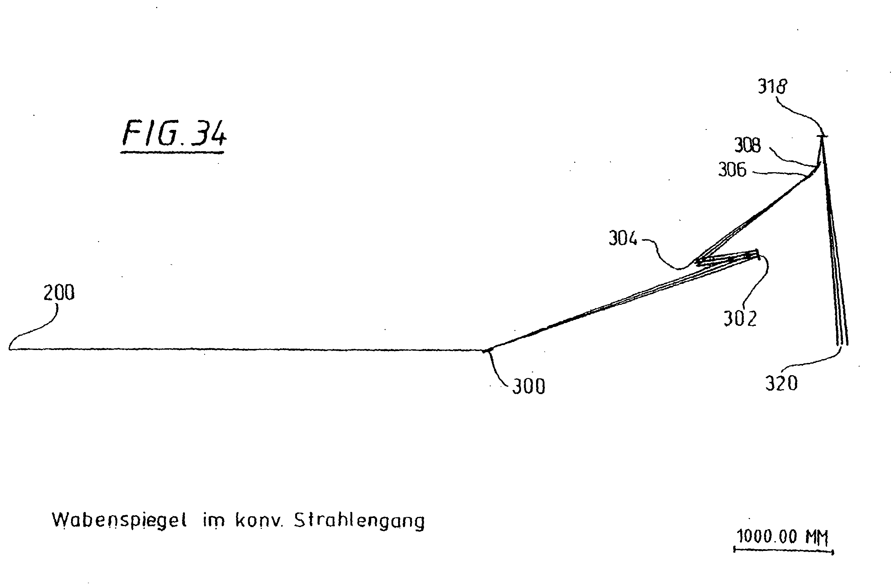

In den Figuren 34 bis 41 wird eine Ausführungsform der Erfindung gemäß Typ B mit facettiertem Spiegel im konvergenten Strahlengang gezeigt. Die Lichtquelle wird, wie bei der Ausführungsform gemäß den Figuren 26 bis 33 beschrieben, angenommen. Die Facetten bzw. Rasterelemente sind wie in Figur 25 angeordnet und als sammelnde Hohlfacetten, die auf einer planen Trägerfläche aufgebracht sind, ausgebildet.

Die Anordnung der Spiegel bezogen auf das globale Koordinatensystem der Quelle ist in Tabelle Tab. 2 zusammengestellt:

Tab. 2:

| Anordnung der Spiegel für Typ B. | | | | | | | | |
|---|---|---|---|---|---|---|---|---|
| Komponente | X [mm] | Y [mm] | Z [mm] | α [°] | β [°] | γ [°] | AOI [°] | |
| Quelle | 0.000 | 0.000 | 0.000 | 0.000 | 0.000 | 0.000 | 0.000 | - |
| Zerstreuspiegel | 0.000 | 0.000 | 5000.000 | 80.000 | 0.000 | 0.000 | 80.000 | g.i. |
| Sammelspiegel | 0.000 | 1026.060 | 7819.078 | -15.000 | 0.000 | 180.000 | 5.000 | n.i. |
| Spiegel mit Facetten | 0.000 | 913.189 | 7178.953 | 155.000 | 0.000 | 0.000 | 15.000 | n.i. |
| Blende | 0.000 | 1041.747 | 7332.162 | -40.000 | 0.000 | 180.000 | 0.000 | - |
| Feldspiegel 1 | 0.000 | 1917.187 | 8375.471 | 38.858 | 0.000 | 180.000 | 78.858 | g.i. |
| Feldspiegel 2 | 0.000 | 2049.977 | 8445.234 | 16.573 | 0.000 | 0.000 | 78.857 | g.i. |
| Retikel | 0.000 | 2298.855 | 8468.892 | 90.000 | 180.000 | 0.000 | 5.430 | n.i. |
| EP Objektiv | 0.000 | 79.114 | 8679.892 | 90.000 | 0.000 | 0.000 | 0.000 | - |
| X, Y, Z: Koordinatenursprung der Komponenten. α, β, γ : Drehwinkel der Flächen. AOI: Inzidenzwinkel der optischen Achse an den Komponenten. g.i./n.i.: grazing incidence/normal incidence. | | | | | | | | |

Die z-Achse der Retikelebene steht unter 90° zur z-Achse des Quellkoordinatensystems.

Der z-Abstand zwischen Quelle 200 und Sammelspiegel 302 beträgt 5000 mm. Für die nicht dargestellte Strahlenschutzwand ist ein z-Abstand zwischen Zerstreuspiegel 300 und dem Facttenspiegel 304 von 2100 mm vorgesehen.

Die Retikelebene 318 liegt 2298.9 mm über der Quelle.

Figur 34 zeigt das Gesamtsystem bis zur Eintrittspupille 320 des Objektivs im yz-Schnitt umfassend: Quelle 200, Zerstreuspiegel 300, Sammelspiegel 302, Facettenspiegel 304, Feldspiegel 306, 308, Retikelebene 318, Eintrittspupille Objektiv 320. Eingezeichnet sind für die zentrale Feldwabe (0,0) und die beiden äußeren Feldwaben jeweils die Mittenstrahlen, die sich in der Retikelebene treffen und die Eintrittspupille des Objektivs ausleuchten.

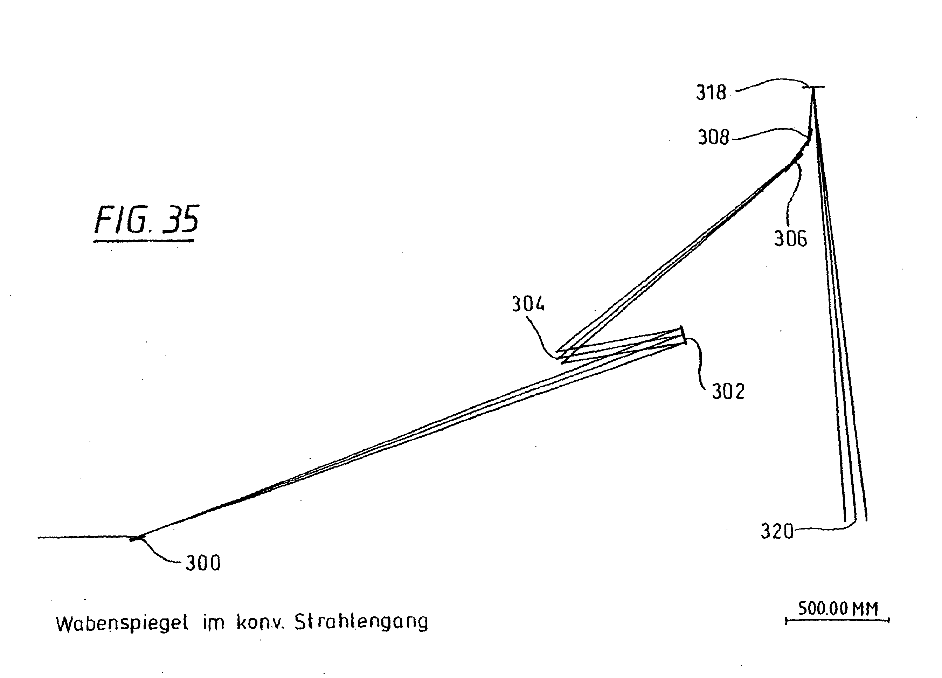

In Figur 35 ist ein Ausschnitt ab dem Zerstreuspiegel 300 dargestellt. Die eingezeichneten Randstrahlen werden vom Facettenspiegel 304 nicht beeinflußt, da es sich um Mittenstrahlen handelt und die Facetten auf einer planen Trägerplatte angebracht sind.

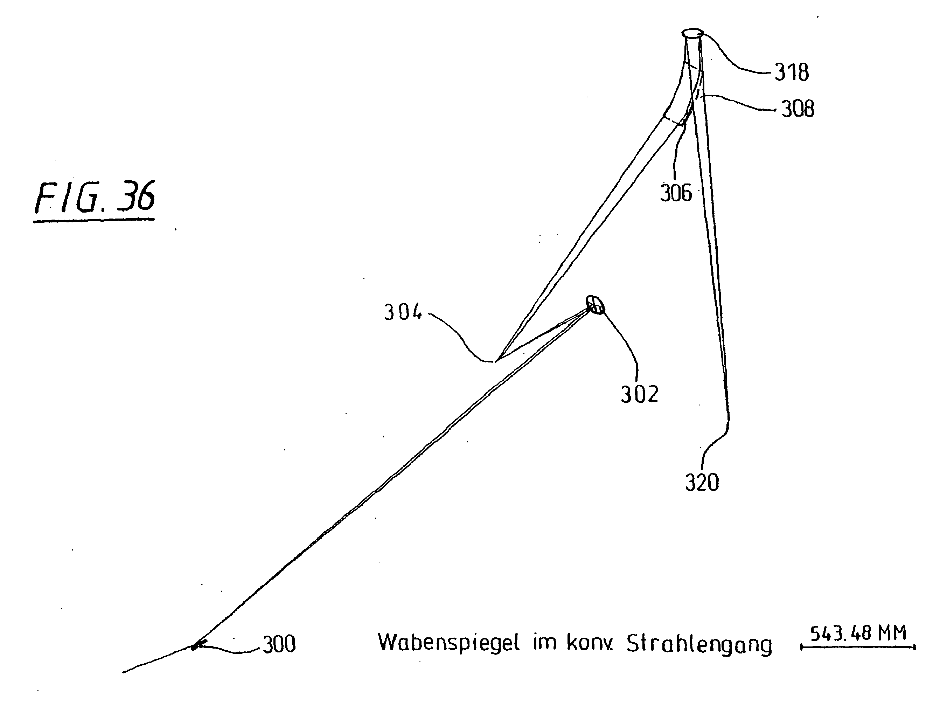

In Figur 36 eingezeichnet ist ein Fan von Strahlen, der die zentrale Wabe (0,0) trifft. Die sammelnde Wirkung der Wabe erzeugt in der Blendenebene die sekundäre Lichtquelle. Die Feldspiegel 306, 308 formen das Ringfeld und bilden die sekundäre Lichtquelle in die Eintrittspupille des Objektivs ab.

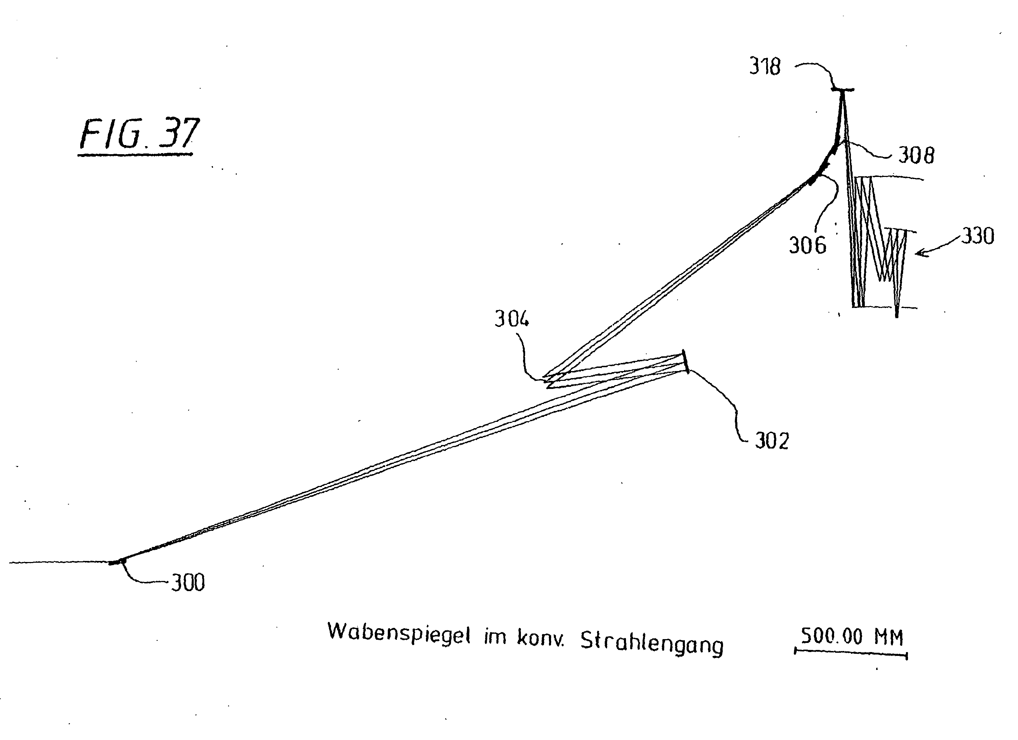

Figur 37 zeigt das Gesamtsystem mit Objektiv im yz-Schnitt umfassend: Zerstreuspiegel 300, Sammelspiegel 302, Facettenspiegel 304 im konvergenten Strahlengang, Feldspiegel 306, 308, Retikelebene 318 und 4-Spiegler-Objektiv 330. Das Strahlbüschel läuft getrennt vom Beleuchtungssystem ins Objektiv.

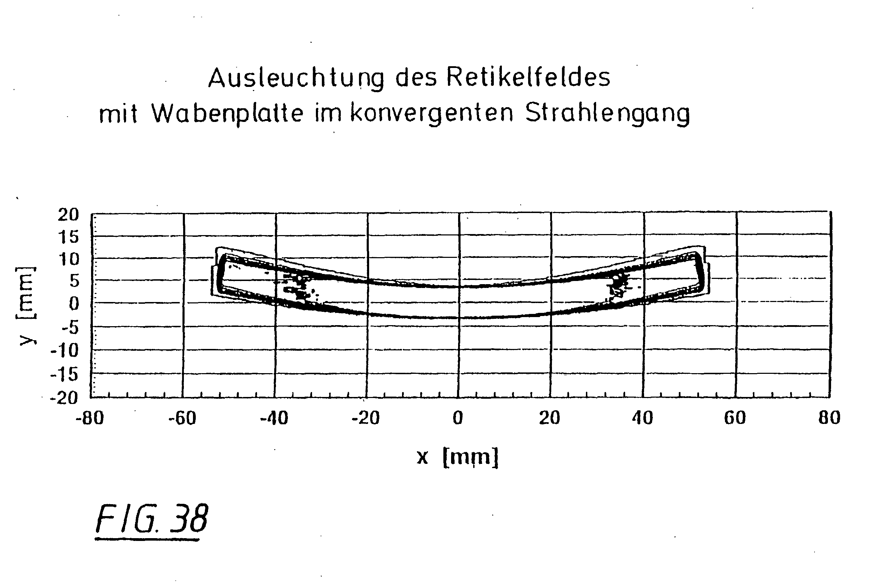

In Figur 38 dargestellt ist die Ausleuchtung des Retikels mit dem $30°$-Ringfeld (r = 211 mm; -3.0 mm < $\Delta r$ < +3.0 mm) in Höhenlinien-Darstellung. Hierbei ist r der Ringradius, wobei aus dem Ring ein $30°$-Segment verwendet wird.

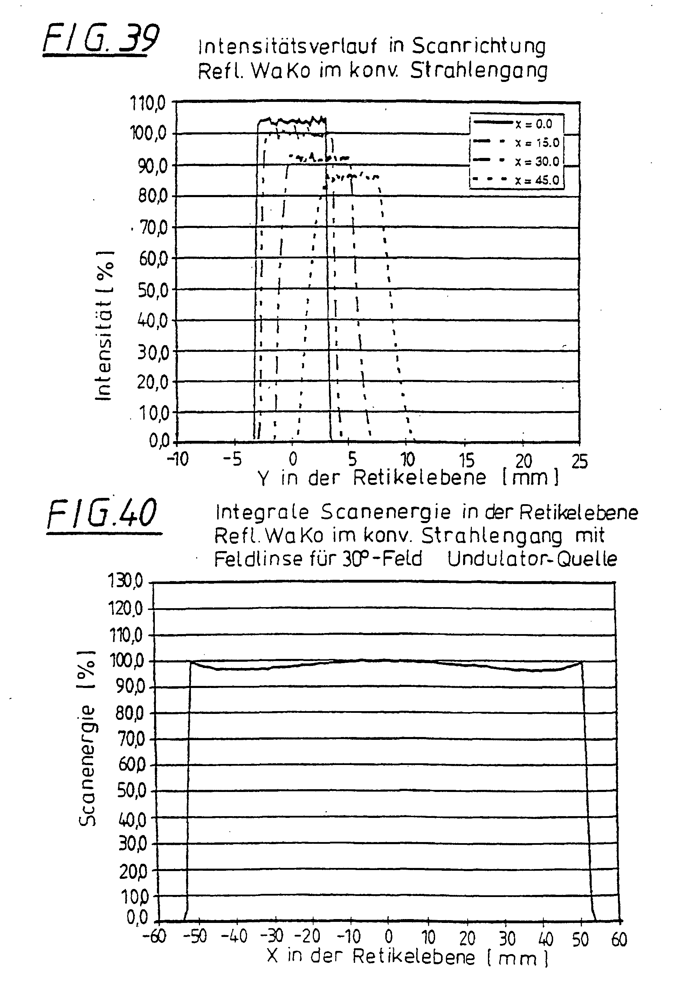

Figur 39 zeigt einen Intensitätsschnitt parallel zur y-Achse bei x = 0,0, 15 mm, 30 mm, 45 mm. Aufgrund der minimalen Ausdehnung der sekundären Lichtquellen entsteht ein ideales "Hut"-Profil zumindest in der Feldmitte. Die Breite der Intensitätsprofile nimmt zum Feldrand hin wegen der Ringkrümmung und der nicht optimalen Überlagerung der Teilbilder zu. Die Maximalintensität nimmt mit der Verbreiterung der Flanken und der größeren Halbwertsbreite ab, so daß die Scan-Energie konstant bleibt.

Wie Figur 40 zeigt, ist die integrale Scan-Energie vorliegender Ausführungsform nahezu homogen.

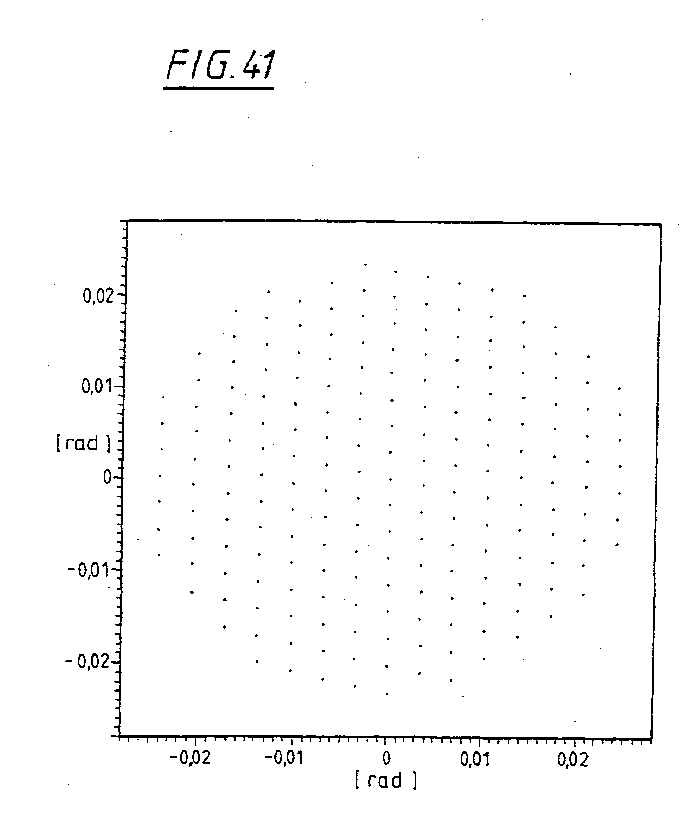

In Figur 41 dargestellt ist die Pupillenausleuchtung in der Feldmitte.

Nachfolgend sollen Beleuchtungssysteme vom Typ C beschrieben werden. Die Undulator-Lichtquelle wird wie zuvor als punktförmige Lichtquelle angenommen.

Das System gemäß Typ C umfaßt in einer ersten Ausführungsform gemäß Typ C1 einen ersten grazing incidence Kollektorspiegel 400 der die Strahlung nach unten ablenkt. Der Spiegel 400 weitet den Strahl auf und beleuchtet den facettierten Spiegel 402, der die Strahlung wieder Richtung Undulator-Quelle 200 umkehrt. Um zu einer vignettierungsfreien Lösung zu kommen, führt der facettierte Spiegel 402 zusätzlich einen Kipp der optischen Achse um die y-Achse, den sogenannten β-Kipp, ein. Dadurch läuft die Systemachse an der Strahlenschutzwand vorbei.

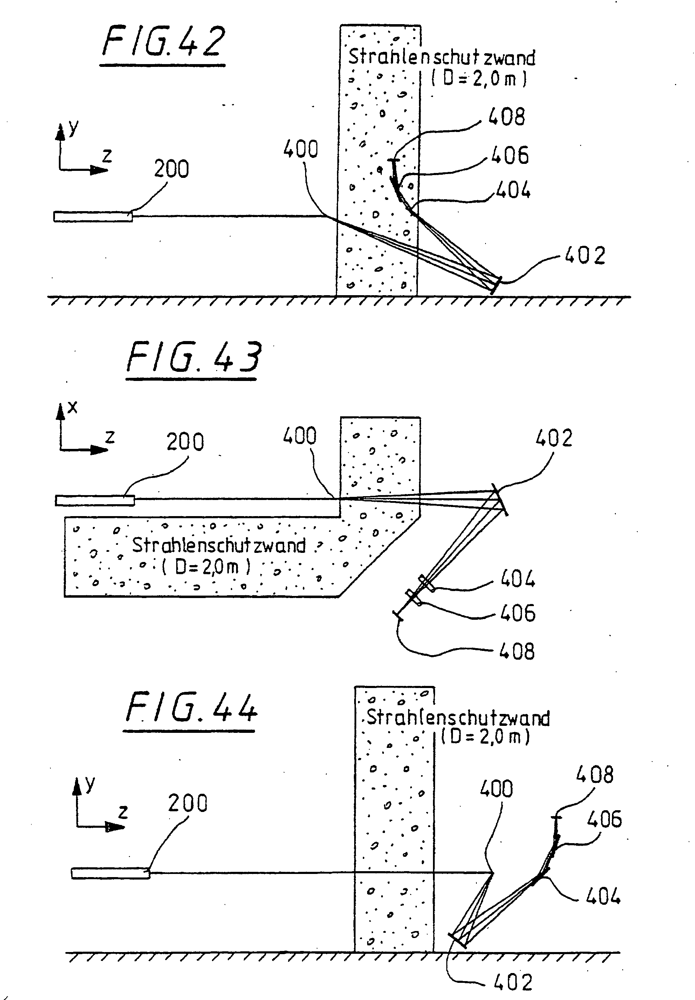

Figur 42 zeigt die Seitenansicht in der y-z-Ebene eines derartigen Systems, Figur 43 die Draufsicht in der x-z-Ebene.

Die zweite Ausführungsform Typ C2 eines Systems gemäß Typ C zeigt Figur 44.

Beim System gemäß Typ C2 ist der grazing incidence Spiegel 402 durch einen normal incidence Spiegel ersetzt. Dies hat zur Folge, daß die Systemachse nach den zwei Reflektionen bei Spiegel 402 und facettiertem Spiegel 404 wieder von der Undulator-Quelle weg läuft. Die Spiegel müssen dann nur um die x-Achse gekippt werden, sogenannter α-Kipp. Ein Kipp der optischen Achse um die y-Achse wie beim Typ C1 ist nicht erforderlich Der Spiegel 402 zur Strahlaufweitung befindet sich beim Typ C2 außerhalb der Quellkammer. Da die Quellstrahlung in horizontaler Richtung nahezu linear polarisiert ist, kann die optische Achse beim Strahlaufweitungsspiegel 402 auch um größere Winkel ohne große Verluste umgelenkt werden.

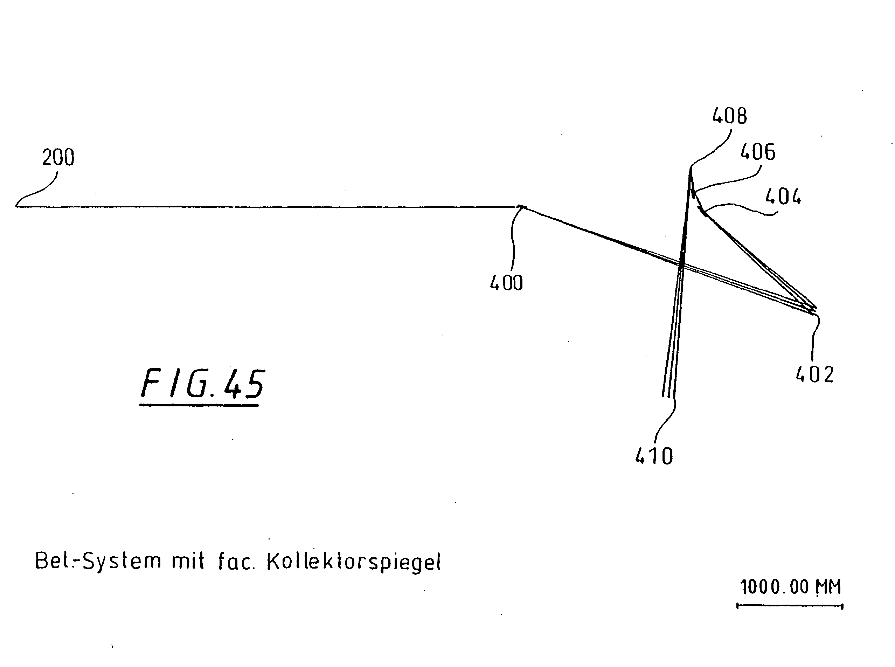

In den Figuren 45 bis 54 ist ein System gemäß Typ C1 nochmals eingehender dargestellt.

Die Anordnung der Spiegel dieses in den Figuren 45 bis 54 gezeigten Systems ist in in Tabelle Tab. 3 zusammengestellt.

Tab. 3:

| Anordnung der Spiegel für Typ C1. | | | | | | | | |
|---|---|---|---|---|---|---|---|---|
| Komponente | X [mm] | Y [mm] | Z [mm] | $\alpha$ [°] | $\beta$ [°] | $\gamma$ [°] | AOI [°] | |
| Quelle | 0.000 | 0.000 | 0.000 | 0.000 | 0.000 | 0.000 | 0.000 | - |
| Zerstreuspiegel | 0.000 | 0.000 | 5000.000 | -80.000 | 0.000 | 0.000 | 80.000 | g.i. |
| Spiegel mit Rasterlementen | 0.000 | -1026.060 | 7819.078 | 31.039 | 9.462 | 179.084 | 14.501 | n.i. |
| Blende | -63.666 | -697.503 | 7679.723 | 222.692 | -18.562 | 16.366 | 0.000 | - |
| Feidspiegel 1 | - 493.075 | -30.412 | 6739.809 | 138.466 | -18.880 | -15.994 | 78.858 | g.i. |
| Feldspiegel 2 | -531.728 | 146.641 | 6655.203 | -18.117 | 203.471 | -7.425 | 78.857 | g.i. |
| Retikel | -539.593 | 345.744 | 6637.988 | 270.000 | 0.000 | 24.554 | 5.430 | n.i. |

Tab. 3:   (fortgesetzt)

| Anordnung der Spiegel für Typ C1. | | | | | | | | |
|---|---|---|---|---|---|---|---|---|
| Komponente | X [mm] | Y [mm] | Z [mm] | α [°] | β [°] | γ [°] | AOI [°] | |
| EP Objektiv | -627.274 | -1873.997 | 6446.069 | 90.000 | 0.000 | 155.446 | 0.000 | - |
| X, Y, Z: Koordinatenursprung der Komponenten. | | | | | | | | |
| α, β, γ : Drehwinkel der Flächen. | | | | | | | | |
| AOI: Inzidenzwinkel der optischen Achse an den Komponenten. | | | | | | | | |
| g.i./n.i.: grazing incidence/normal incidence. | | | | | | | | |

Die z-Achse der Retikelebene steht unter 90° zur z-Achse des Quellkoordinatensystems.

Der z-Abstand zwischen Quelle und Zerstreuspiegel beträgt 5000 mm. Durch den Kipp des Facettenspiegels um die x- und y-Achse wird die zurücklaufende optische Achse so gedreht, daß das Objektiv nicht mit dem Beleuchtungsstrahlengang und der Strahlenschutzwand in die Quere kommt.

Der Facettenspiegel liegt um -1026.1 mm unter der Quelle, die Retikelebene 345.79 mm über der Quelle.

Das beispielhafte Design vom Typ C1 soll nun anhand der Abbildungen näher beschrieben werden:

Figur 45 zeigt das Gesamtsystem bis zur Eintrittspupille des Objektivs im yz-Schnitt umfassend: Quelle 200, Zerstreuspiegel 400 facettierter Spiege 402 mit sammelnder Wirkung, Feldspiegel 404, 406, Retikelebene 408, Eintrittspupille 410 des Objektives. Eingezeichnet sind für die zentrale Feldwabe (0,0) und die beiden äußersten Feldwaben jeweils die Mittenstrahlen. Sie treffen sich in der Retikelebene und leuchten die Eintrittspupille des Objektivs aus.

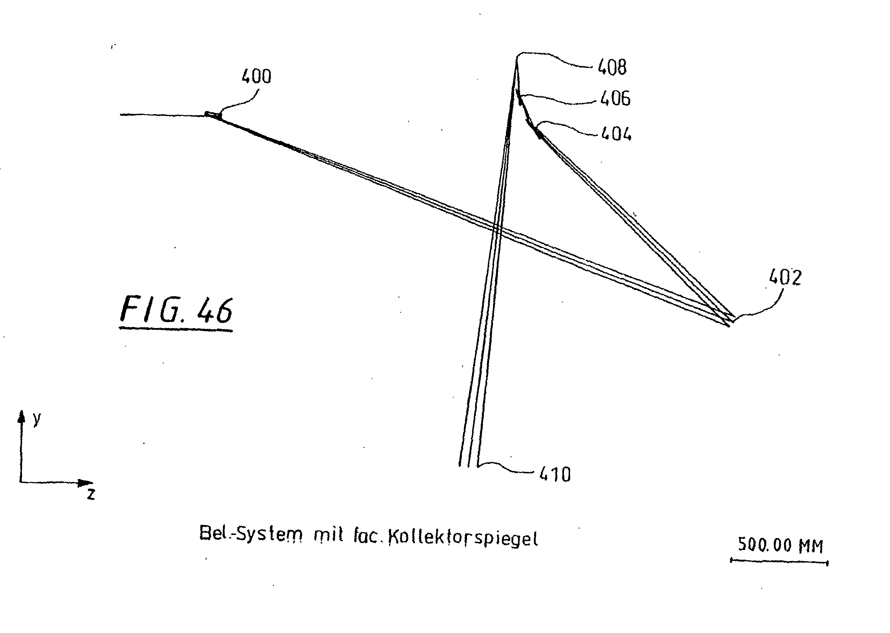

Figur 46 zeigt einen Ausschnitt ab dem Zerstreuspiegel 400 im x-z-Schnitt. Die eingezeichneten Randstrahlen werden vom Facettenspiegel so umgelenkt, daß sie in der Retikelebene zusammentreffen.

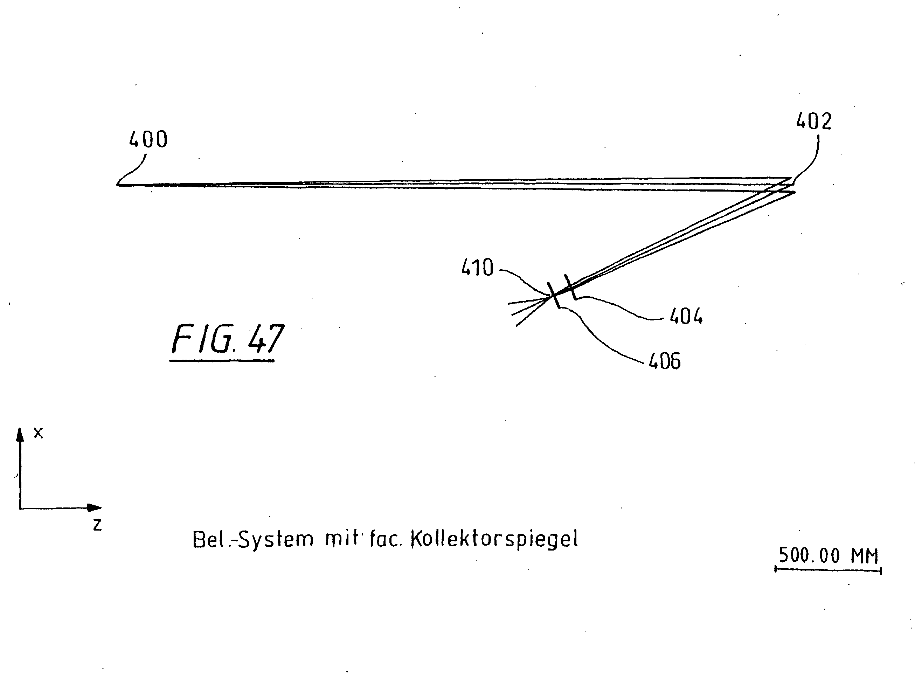

In Figur 47 ist der Ausschnitt ab dem Zerstreuspiegel 400 im x-z-Schnitt dargestellt. Der facettierte Spiegel 402 mit sammelnder Wirkung kippt die optische Achse vom einlaufenden Strahlbüschel weg. Dadurch wird für das Objektiv und die Strahlenschutzwand Platz geschaffen.

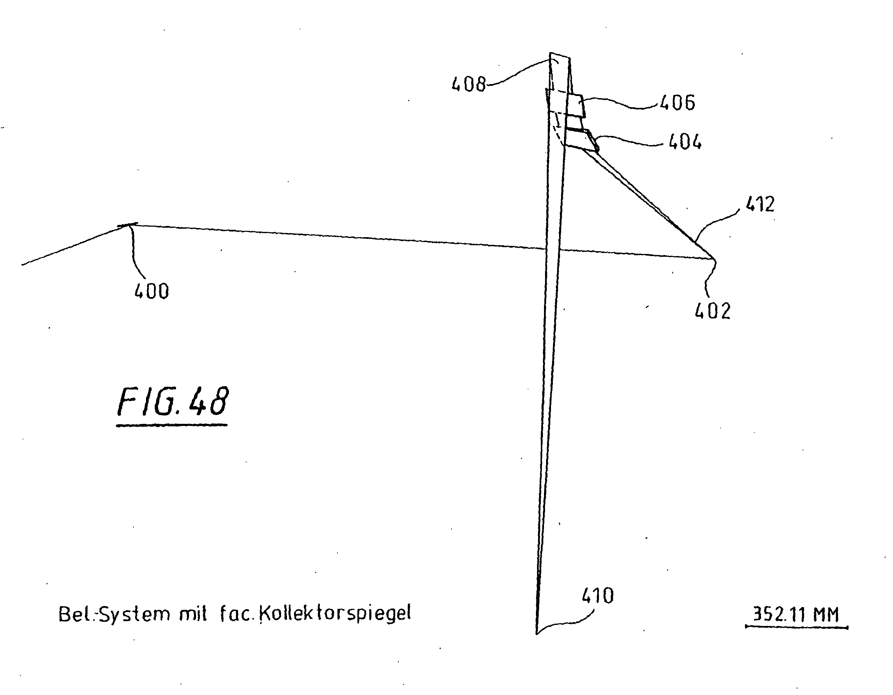

In Figur 48 ist ein Fan von Strahlen, der die zentrale Wabe (0,0) trifft, eingezeichnet. Die sammelnde Wirkung der Wabe erzeugt in der Blendenebene die sekundäre Lichtquelle. Die Feldspiegel 404, 406 formen das Ringfeld und bilden die sekundäre Lichtquelle 412 in die Eintrittspupille 410 ab.

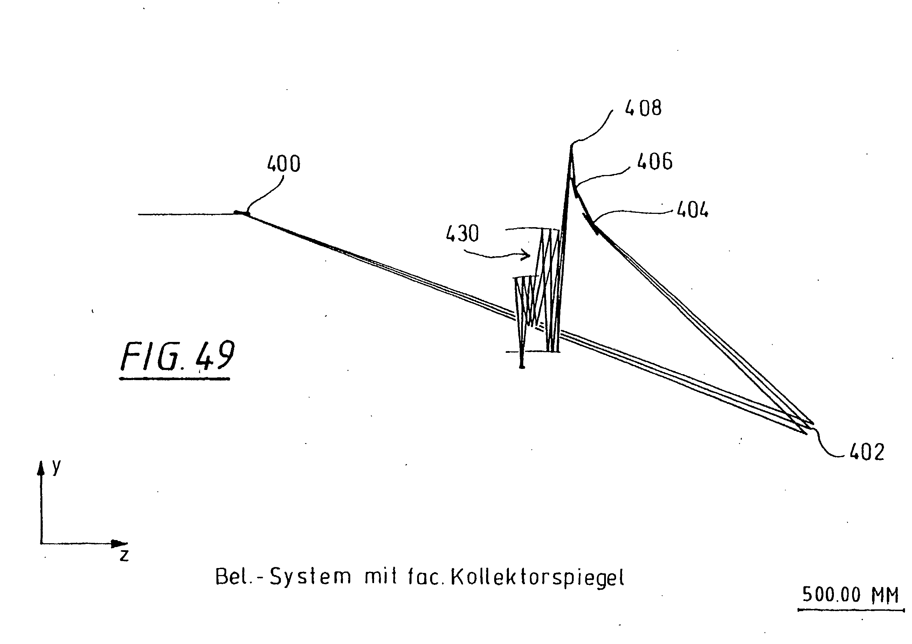

Figur 49 zeigt das Gesamtsystem mit Objektiv im y-z-Schnitt umfassend Zerstreuspiegel 400, facettierter Spiegel 402 mit sammelnder Wirkung, Feldspiegel 404, 406, Retikelebene 410, 4-Spiegel-Objektiv 430. Das Strahlenbüschel läuft getrennt vom Beleuchtungssystem ins Objektiv.

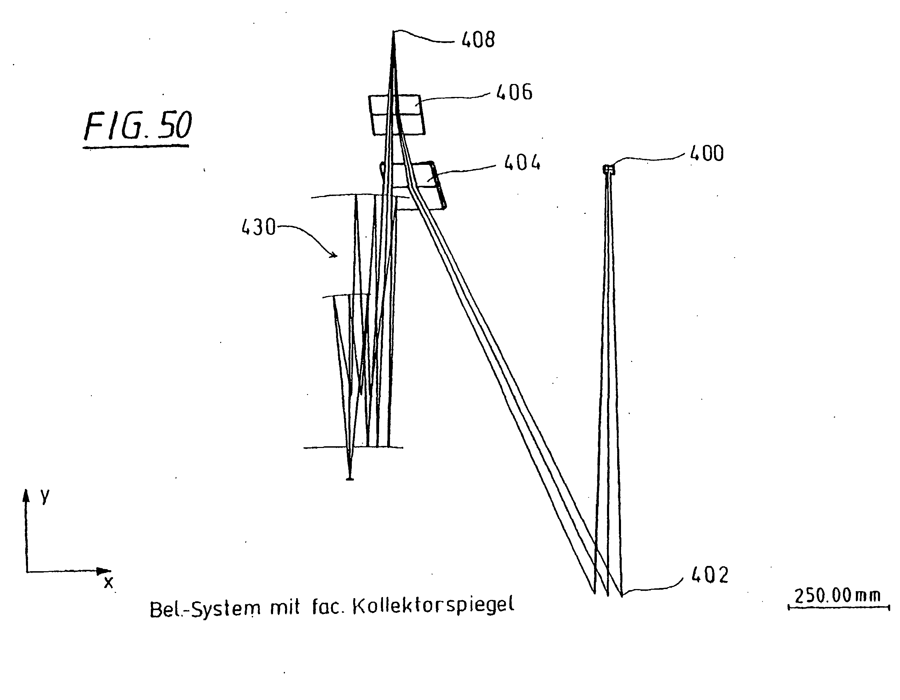

In Figur 50 ist das Gesamtsystem mit Objektiv im x-y-Schnitt dargestellt. In dieser Ansicht wird die Trennung von Objektiv und dem Beleuchtungsstrahlengang zwischen Zerstreuspiegel 400 und Facettenspiegel 402 deutlich.

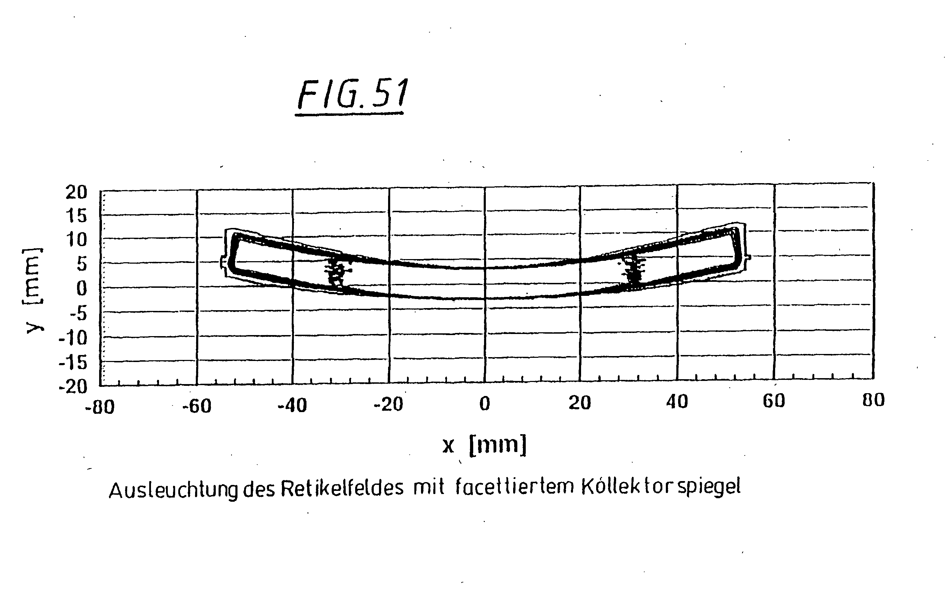

Figur 51 zeigt die Ausleuchtung des Retikels mit dem 30°-Ringfeld (r = 211 mm; -3. mm < Δr < +3.0 mm) in Höhenlinien-Darstellung.

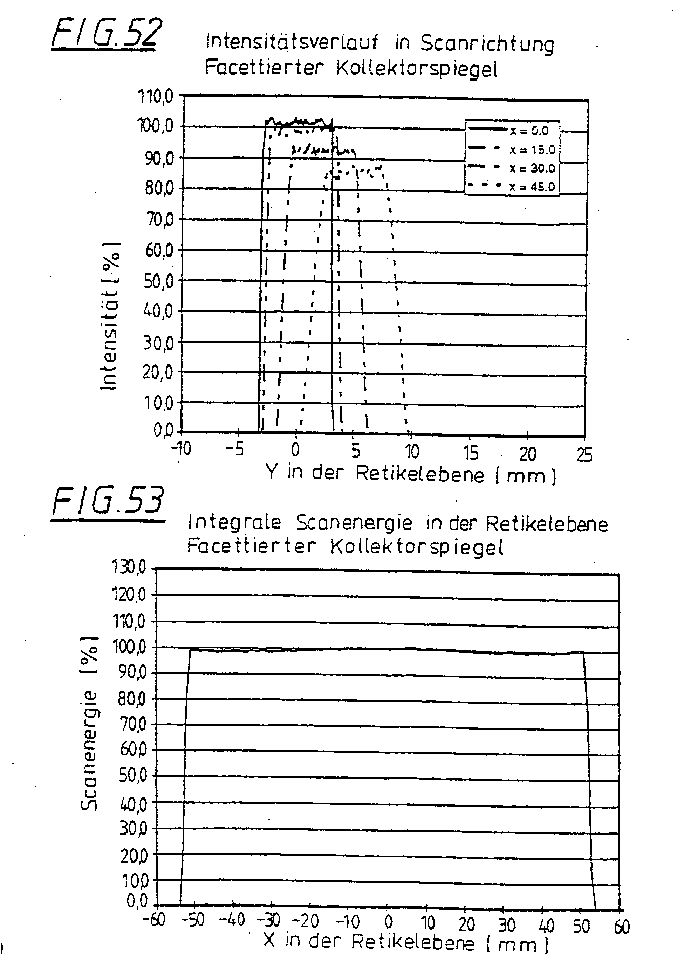

In Figur 52 ist ein Intensitätsschnitt parallel zur y-Achse bei x = 0.0, 15 mm, 30 mm, 45 mm dargestellt.

Wie aus Figur 53 zu ersehen, ist die integrale Scan-Energie vorliegender Ausführungsform homogen.

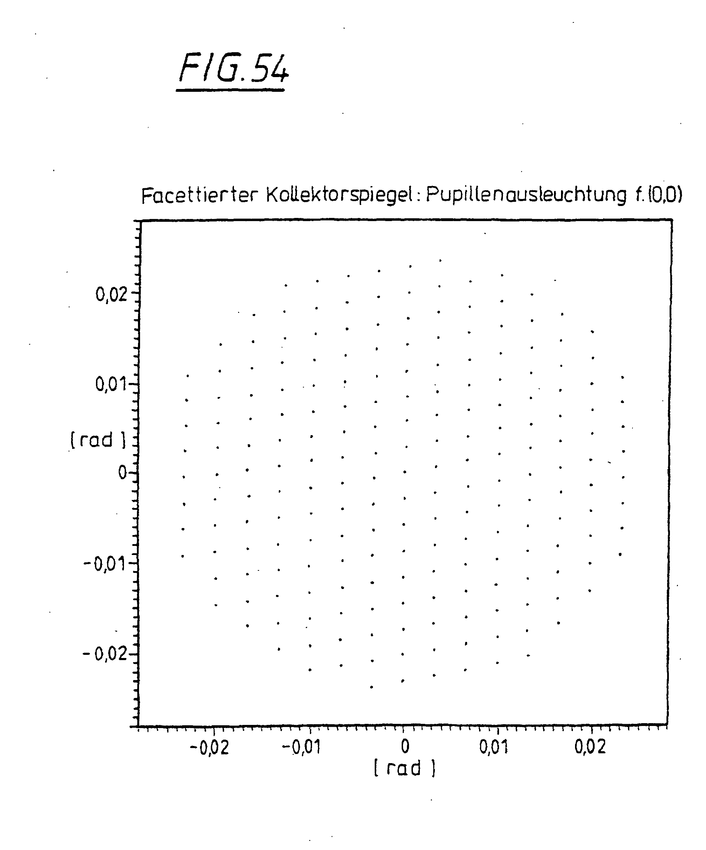

Die Pupillenausleuchtung in der Feldmitte eines Systems vom Typ C1 ist in Figur 54 dargestellt.

Ist es nicht erforderlich, daß die Blendenebene zugänglich ist, so kann man auch mit einer virtuellen Blendenebene arbeiten. Das Licht würde dann die Spiegelfacetten divergent verlassen. Gemäß Typ B und Typ C wären die Facetten nicht sammelnd, sondern zerstreuend ausgebildet.

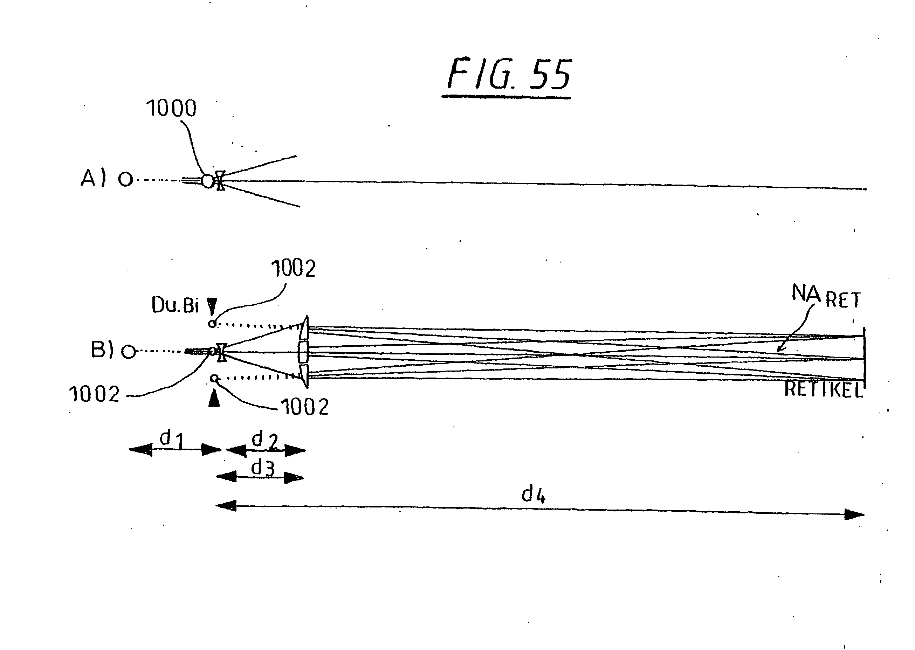

Für Typ C ist folgender Fall vorstellbar. Der erste Kollektorspiegel erzeugt eine virtuelle sekundäre Lichtquelle 1000, wie in Abb. 55A gezeigt. Die divergierenden Strahlen werden von Planspiegeln so umgelenkt, daß ihre Mittenstrahlen die Retikelebene auf der optischen Achse schneiden. Die gekippten Planspiegel sind in Abb. 55B als Prismen dargestellt. Dadurch werden in der virtuellen Blendenebene eine Vielzahl von sekundären Lichtquellen 1002, erzeugt.

Folgende Formeln beschreiben den Zusammenhang der Systemparameter gemäß den Figuren 55A und B:

$$NA_{Ret} = \frac{DU_{BL}/2}{d_4} \qquad\qquad \Rightarrow DU_{BL} = 2 \cdot d_4 \cdot NA_{Ret}$$

$$\frac{DU_{BL}}{x_{Wabe}} \cdot \frac{d_4 + |d_3|}{d_4} = 4.0 \qquad\qquad \Rightarrow x_{Wabe} = \frac{DU_{BL}}{4.0} \cdot \frac{d_4}{d_4 + |d_3|}$$

$$\beta_{Wabe} = \frac{x_{Feld}}{x_{Wabe}} = \frac{d_4}{|d_3|} \qquad\qquad \Rightarrow \beta_{Wabe} = \frac{x_{Feld}}{x_{Wabe}}$$

$$\Rightarrow |d_3| = \frac{d_4}{\beta_{Wabe}}$$

wobei:

$d_4$: Maß für die Baulänge.

$NA_{Ret}$: Apertur in Retikelebene.

Anzahl der Waben in einer Wabenzeile = 4. Dies ist ein Maß für die Anzahl der sekundären Lichtquellen, der Uniformität des Feldes und der gleichmäßigen Ausleuchtung der Pupille.

$X_{Feld}$: x-Ausdehnung des Feldes.

Aus der schematischen Darstellung gemäß den Figuren 55A - B wird deutlich, daß für die Undulator-Quelle mit $NA_{Quelle}$ = 0.001 die Abstände $d_2$ und $d_3$ ungefähr gleich groß sind. Zusammen mit einer realisierbaren Baulänge wird dies in der praktischen Umsetzung einen normal incidence Kollektorspiegel erfordern.

Um die scharfen Intensitäts-Peaks wie zum Beispiel in Figur 54 gezeigt in der Pupille zu verschmieren und den Lichtleitwert effektiv zu erhöhen, kann bei sämtlichen Ausführungsformen der Erfindung der letzte Feldspiegel als sich bewegender Spiegel, sogenannter wobbelnder Feldspiegel, ausgelegt werden. Die Bewegung eines wobbelnden Feldpiegels verändert primär die Aperturwinkel und hat geringen Einfluß auf die Feldlage.

Neben einer Bewegung des gesamten Spiegels ist auch eine periodische Oberflächenänderung des letzten Spiegels denkbar, um die Verschmierung der scharfen Intensitäts-Peaks in der Pupille zu erreichen.

Zur Reduzierung des Waben-Aspekt-Verhältnisses ist die Verwendung astigmatischer Facetten möglich. Dadurch wird die Blendenebene in eine sagittale und eine tangentiale Blendenebene aufgespalten. Die torischen Feldspiegel bilden diese zwei Ebenen in die Eintrittspupille des Objektives ab.

Durch das Design der Feldlinse kann die Beleuchtungsverteilung in der Retikelebene beeinflußt werden. Zum Beispiel kann dadurch eine uniforme Scanenergie erreicht werden.

Zur Steuerung der Scan-Uniformität kann bei einer weiteren Ausgestaltung der Erfindung einer der beiden Feldspiegel als aktiver Spiegel ausgeführt sein.

Die azimutale Verzeichnung kann durch mehrere Aktuatorzeilen, die in y-Richtung verlaufen, gesteuert werden.

**Patentansprüche**

1. Beleuchtungssystem für Wellenlängen ≤ 193 nm, insbesondere für die EUV-Lithographie mit

    1.1 mindestens einer Lichtquelle (1, 200)

    1.2 mindestens einer Einrichtung zur Erzeugung sekundärer Lichtquellen (218) umfassend mindestens einen ersten Spiegel oder eine erste Linse (7, 9, 100, 304, 402), der bzw. die in Rasterelemente (5,102,214) gegliedert ist;

    1.3 ein oder mehrere optische Elemente (12, 32, 306, 308, 404, 406), die zwischen der Spiegel- oder Linsenvorrichtung, umfassend mindestens einen ersten Spiegel oder eine erste Linse (7, 9, 100, 304, 402), der bzw. die in Rasterelemente (5, 102, 214) gegliedert ist, und einer Bildebene (14, 318, 408) des Beleuchtungssystems angeordnet sind, wobei die optischen Elemente die sekundären Lichtquellen (218) in eine Austrittspupille (26, 320,410) des Beleuchtungssystems abbilden;

    das Beleuchtungssystem ist **dadurch gekennzeichnet, daß**

    1.4 die Lichtquelle (1, 200) eine Lichtquelle zur Erzeugung von Strahlung mit Wellenlängen ≤ 193 nm ist, die in eine ausgezeichnete Ebene mit einem Wellenlängenspektrum abstrahlt, wobei die Quellstrahlung für Wellenlängen innerhalb des für die Anwendung, insbesondere für die Lithographie verwendeten Welfenlängenbereiches eine Strahldivergenz senkrecht zu dieser Ebene aufweist, die kleiner als 5 mrad ist.

2. Beleuchtungssystem nach Anspruch 1, **dadurch gekennzeichnet, daß** die Quellstrahlung für Wellenlängen innerhalb des für die Anwendung, insbesondere für die Lithographie, verwendeten Wellenlängenbereiches in der ausgezeichneten Ebene eine Strahldivergenz < 100 mrad aufweist.

3. Beleuchtungssystem nach Anspruch 1 bis 2, **dadurch gekennzeichnet, daß** das Beleuchtungssystem optische Elemente (206, 300, 400) zur Aufwertung eines von der lichtquelle(1,200) ausgehenden Strahlbüschels senkrecht zur ausgezeichneten Ebene umfaßt.

4. Beleuchtungssystem nach einem der Ansprüche 1 bis 3, **dadurch gekennzeichnet, daß** die Quellstrahlung für Wellenlängen innerhalb des für die Anwendung, insbesondere für die Lithographie, verwendeten Wellenlängenbereiches in der ausgezeichneten Ebene eine Strahldivergenz aufweist, die kleiner als 5 mrad ist.

5. Beleuchtungssystem nach einem der Ansprüche 1 bis 4, **dadurch gekennzeichnet, daß** optische Elemente (206, 300, 400) zur Aufweitung des von der Lichtquelle (1,200) ausgehenden Strahlbüschels in der ausgezeichneten Ebene und senkrecht zur ausgezeichneten Ebene vorgesehen sind.

6. Beleuchtungssystem nach einem der Ansprüche 1 bis 5, **dadurch gekennzeichnet, daß** die optischen Elemente (206, 300, 400) zur Aufweitung des von der Lichtquelle (1,200) ausgehenden Strahlbüschels einen Zerstreuspiegel (400) bzw. eine Zerstreulinse umfassen.

7. Beleuchtungssystem nach Anspruch 6, **dadurch gekennzeichnet, daß** der Zerstreuspiegel (400) ein grazing-incidence-Spiegel ist.

8. Beleuchtungssystem nach einem der Ansprüche 3 bis 5, **dadurch gekennzeichnet, daß** die optischen Elemente (206, 300, 400) zur Aufweitung des von der Lichtquelle (1,200) ausgehenden Strahlbüschels einen Scanspiegel umfassen.

9. Beleuchtungssystem nach einem der Ansprüche 3 bis 8, **dadurch gekennzeichnet, daß** optische Elemente (208, 302) zum Sammeln des aufgeweiteten Strahlbüschels vorgesehen sind.

10. Beleuchtungssystem nach einem der Ansprüche 1 bis 9 , **dadurch gekennzeichnet, daß** die Quellstrahlung Wellenlängen in einem Bereich von 10nm bis 15nm aufweist.

11. Beleuchtungssystem nach einem der Ansprüche 1 bis 10, **dadurch gekennzeichnet, daß** die Strahlungsquelle eine Synchrotronstrahlungsquelle ist.

12. Beleuchtungssystem nach Anspruch 11, **dadurch gekennzeichnet, daß** die Synchrotron-Strahlungsquelle, einen Wiggler oder eine Undulator-Quelle umfaßt.

13. Beleuchtungssystem nach einem der Ansprüche 1 bis 12 , **dadurch gekennzeichnet, daß** die Rasterelemente (5,102,214) des ersten Spiegels (7, 304, 402) die sekundären Lichtquellen (218) erzeugen.

14. Beleuchtungssystem nach einem der Ansprüche 1 bis 13, **dadurch gekennzeichnet, daß** die Rasterelemente (102,114) des ersten Spiegels oder der ersten Linse (7, 304, 402), der bzw. die in Rasterelemente gegliedert ist, derart geformt und angeordnet sind, daß die Bilder der Rasterelemente durch die optischen Elemente (12, 32, 306, 308, 404, 406) in der Bildebene (14, 318) des Beleuchtungssystems zum überwiegenden Teil zur Deckung kommen.

15. Beleuchtungssystem gemäß Anspruch 14, **dadurch gekennzeichnet,daß** Rasterelemente derart geformt und angeordnet sind, daß die durch Apertur und Füllgrad definierte Austrittspupille (24) des Beleuchtungssystems beleuchtet wird.

16. Beleuchtungssystem gemäß einem der Ansprüche 9 bis 15, **dadurch gekennzeichnet, daß** die optischen Elemente zum Sammeln des aufgeweiteten Strahlenbüschels mindestens einen Sammelspiegel oder einer Sammellinse (208, 302) umfassen.

17. Beleuchtungssystem gemäß Anspruch 3 bis 16, **dadurch gekennzeichnet, daß** die Kollektoreinheit umfassend optische Elemente zum Aufweiten und/oder Sammeln derart aufgebaut ist, daß der erste Spiegel (7, 304, 402) mit Rasterelementen (214) nahezu rund ausgeleuchtet wird.

18. Beleuchtungssystem gemäß einem der Anspruch 3 bis 17, **dadurch gekennzeichnet, daß** die Kollekoreinheit umfassend optische Elemente zum Aufweiten und/oder Sammeln die Lichtquelle (1, 200) in eine Blendenebene (212) abbildet.

19. Beleuchtungssystem gemäß einem der Ansprüche 13 bis 18, **dadurch gekennzeichnet, daß** die Rasterelemente (214) als Planfacetten ausgebildet sind.

20. Beleuchtungssystem gemäß Anspruch 19, **dadurch gekennzeichnet, daß** die Planfacetten des Spiegels (7, 304, 402) mit Rasterelementen (214) auf der Spiegeloberfläche derart gekippt angeordnet werden, daß die Mittenstrahlen jeder Planfacette in der Bildebene (14, 318) auf einer optischen Achse (222), die durch die Mitte eines auszuleuchtenden Feldes in der Bildebene geht, zusammentreffen.

21. Beleuchtungssystem gemäß einem der Ansprüche 13 bis 18, **dadurch gekennzeichnet, daß** die Rasterelemente (214) Prismen sind, die derart orientiert und angeordnet sind, daß die Mittenstrahlen jedes Prismas in der Bildebene (14, 318) auf einer optischen Achse, die durch die Feldmitte der Bildebene geht, zusammentreffen.

22. Beleuchtungssystem gemäß Anspruch 3 bis 17, **dadurch gekennzeichnet, daß** die Kollektoreinheit umfassend optische Elemente zum Sammeln und/oder Aufweiten die Lichtquelle (1, 200) in die Bildebene (14, 318) abbildet.

23. Beleuchtungssystem nach Anspruch 13 bis 17, **dadurch gekennzeichnet, daß** die Rasterelemente (214) sammelnde Wirkung aufweisen, derart, daß in einer Blendenebene sekundäre Lichtquellen (212, 1002) ausgebildet werden.

24. Beleuchtungssystem nach einem der Ansprüche 3 bis 23, **dadurch gekennzeichnet, daß** der Abstand Lichtquelle (200) zu den optischen Elementen zur Aufweitung des Strahlbüschels (206,300,400) mindestens 2000 mm beträgt.

25. Beleuchtungssystem nach Anspruch 24, **dadurch gekennzeichnet, daß** der Abstand von den optischen Elementen zur Aufweitung des Strahlbüschels (206, 300, 400) zur weiteren Optik des Beleuchtungssystems, umfassend Mittel zum Sammeln des Strahlbüschels (208,302), mindestens einen Spiegel (402), der in Rasterelemente gegliedert ist sowie optische Elemente, die die sekundären Lichtquellen (112, 216, 412, 1000) in die Austrittspupille des Beleuchtungssystems abbilden, mindestens 1000 mm beträgt.

26. Beleuchtungssystem nach Anspruch 1 bis 25, **dadurch gekennzeichnet, daß** die sämtlichen optischen Elemente des Beleuchtungssystems derart angeordnet sind, daß die optische Achse, die an der Strahlungsquelle in einer horizontalen Ebene läuft, derart umgelenkt wird, daß die optische Achse auf eine in einer horizontalen Ebene angeordnete Bildebene (14, 318, 408) unter einem Winkel zwischen Flächennormale und optischer Achse an der Bildebene von höchstens 20°, vorzugsweise höchstens 10° trifft.

27. Beleuchtungssystem nach einem der Ansprüche 1 bis 15, **dadurch gekennzeichnet, daß** die Rasterelemente (214) des ersten Spiegels bzw. der ersten Linse (402) mit Rasterelementen derart ausgestaltet sind, daß durch die Anordnung der Rasterelemente die sammelnde Wirkung der optischen Elemente zum Sammeln des Strahlenbüschels dargestellt wird.

28. Beleuchtungssystem nach Anspruch 27, **dadurch gekennzeichnet, daß** die Rasterelemente (214) des ersten Spiegels (402) mit Rasterelementen auf der Spiegeloberfläche derart gekippt angeordnet werden, daß die Mittenstrahlen jedes Rasterelementes in der Bildebene (14, 318) auf einer optischen Achse, die durch die Mitte eines auszuleuchtenden Feldes in der Bildebene (14,318) geht, zusammentreffen.

29. Beleuchtungssystem nach Anspruch 27 oder 28, **dadurch gekennzeichnet, daß** die Rasterelemente sammelnde Wirkung aufweisen, derart, daß in einer Blendenebene (212) sekundäre Lichtquellen (112, 216, 412, 1000) ausgebildet werden.

30. Beleuchtungssystem nach Anspruch 27, **dadurch gekennzeichnet, daß** die Rasterelemente Prismen sind, die derart orientiert und angeordnet sind, daß die Mittenstrahlen jedes Prismas in der Bildebene (14, 318) auf einer optischen Achse, die durch die Feldmitte der Bildebene (14, 318) geht, zusammentreffen.

31. Beleuchtungssystem nach einem der Ansprüche 1 bis 30, **dadurch gekennzeichnet, daß** die optischen Elemente zur Aufweitung des Strahlbüschels eine Einrichtung mit einem Spiegel umfassen, die derart bewegt werden kann, daß das Stahlbüschel von der Lichtquelle eine vorbestimmte Fläche auf dem ersten Spiegel (7, 304, 402) mit Rasterelementen (214) überstreicht.

**32.** Beleuchtungssystem nach Anspruch 31, **dadurch gekennzeichnet, daß** die vorbestimmte Fläche rund ist.

**33.** Beleuchtungssystem nach einem der Ansprüche 1 bis 32, **dadurch gekennzeichnet, daß** zwei Spiegel oder Linsen mit Rasterelementen vorgesehen sind, wobei der erste Spiegel oder die erste Linse (7, 304, 402) eine Vielzahl Rasterelementen, die als Feldwaben bezeichnet werden, und der zweite Spiegel oder die zweite Linse eine Vielzahl von Rasterelementen, die als Pupillenwaben (9) bezeichnet werden, umfaßt.

**34.** Beleuchtungssystem nach Anspruch 33, **dadurch gekennzeichnet, daß** die Pupillenwaben (9) am Ort der sekundären Lichtquellen (112, 216, 412, 1000) angeordnet sind.

**35.** Beleuchtungssystem nach einem der Ansprüche 33 bis 34, **dadurch gekennzeichnet, daß** jeder Pupillenwabe eine Feldwabe zugeordnet ist und die Pupillenwaben die Feldwaben zusammen mit den optischen Elementen, die die sekundären Lichtquellen in die Austrittspupille abbilden, in die Bildebene abbilden.

**36.** Beleuchtungssystem nach einem der Ansprüche 33 bis 35, **dadurch gekennzeichnet, daß** die Feldwaben auf dem ersten Spiegel oder der ersten Linse (7, 304, 402) derart angeordnet sind, daß sie sich nicht überschneiden und ihre Bilder eine auszuleuchtende Fläche in der Bildebene (14, 318) abdecken.

**37.** Beleuchtungssystem nach einem der Ansprüche 33 bis 36, **dadurch gekennzeichnet, daß** durch entsprechende Anordnung, insbesondere Verdrehung und Verkippung von reflektiven Fefd- und Pupillenwabe auf den Spiegeln zueinander, ein Lichtweg zwischen einem Paar von Feld- und Pupillenwaben aufgebaut wird.

**38.** Beleuchtungssystem nach einem der Ansprüche 32 bis 36, **dadurch gekennzeichnet, daß** durch Orientierung und Wahl des Ablenkwinkels des prismatischen Anteils von refraktiven Feld- und Pupillenwabe der Linsen ein Lichtweg zwischen einem Paar von Feld- und Pupillenwaben aufgebaut wird.

**39.** Beleuchtungssystem nach einem der Ansprüche 1 bis 38, **dadurch gekennzeichnet, daß** die optischen Elemente aktive Linsen oder Spiegel zur Uniformity-Korrektur umfassen.

**40.** Beleuchtungssystem nach einem der Ansprüche 1 bis 39, **dadurch gekennzeichnet, daß** mindestens einer der Feldspiegel ein wobbelnder Feldspiegel ist.

**41.** Beleuchtungssystem nach einem der Ansprüche 1 bis 40, **dadurch gekennzeichnet, daß** die Rasterelemente der bzw. des ersten in Rasterelemente gegliederten Spiegels oder Linse zur Reduzierung des Wabenaspektverhältnisses als astigmatische Feldwaben ausgebildet sind.

**42.** Projektionsbelichtungsanlage der Mikrolithographie

- mit einem Beleuchtungsssystem nach mindestens einem der Ansprüche 1 bis 41
- einer Maske auf einem Trägersystem
- einem Projektionsobjektiv
- einem lichtempfindlichen Objekt auf einem Trägersystem.

**43.** Projektionsbelichtungsanlage gemäß Anspruch 42, ausgeführt als Scanning-System.

**44.** Projektionsbelichtungsanlage nach mindestens einem der Ansprüche 42 bis 43, **dadurch gekennzeichnet, daß** die Beleuchtungsstärke am lichtempfindlichen Objekt - bei strukturloser Maske - weniger als ± 5 %, vorzugsweise weniger als ± 2 % ortsabhängige Unterschiede aufweist.

**45.** Projektionsbelichtungsanlage nach einem der Ansprüche 42 bis 43, **dadurch gekennzeichnet, daß** die Scan-Energie am lichtempfindlichen Objekt - bei strukturloser Maske - weniger als ± 5 %, vorzugsweise weniger als ± 2 %, ortsunabhängige Unterschiede aufweist.

**46.** Projektionsbelichtungsanlage nach mindestens einem der Ansprüche 42 bis 45, **dadurch gekennzeichnet, daß** ein für EUV transparentes Vakuumfenster im Strahlengang angeordnet ist.

**47.** Projektionsbelichtungsanlage nach Anspruch 46, **dadurch gekennzeichnet, daß** ein Vakuumfenster an einer Einschnürung des Lichtbündels im Beleuchtungssystem angeordnet ist.

**48.** Verfahren zur Herstellung von mikroelektronischen Bauelementen, insbesondere Halbleiterchips mit einer Projektionsbelichtungsanlage gemäß einem der Ansprüche 42 bis 47.

**Claims**

**1.** An illumination system for wavelengths ≤ 193 nm, especially for EUV lithography,

1.1 with at least one light source (1, 200);
1.2 with at least one device for producing secondary light sources (218), comprising at least a first mirror or a first lens (7, 9, 100, 304, 402) which is broken down into raster elements (5, 102, 214);
1.3 one or several optical elements (12, 32, 306, 308, 404, 406) which are arranged between the mirror or lens apparatus comprising at least a first mirror or a first lens (7, 9, 100, 304, 402) which is broken down into raster elements (5,102, 214) and an image plane (14, 318, 408) of the illumination system, with the optical elements projecting the secondary light sources (218) to an exit pupil (26, 320, 410) of the illumination system; the illumination system is **characterized in that**
1.4 the light source (1, 200) is a light source for producing a radiation with wavelengths ≤ 193 nm which radiates into a marked plane with a wavelength spectrum, with the source radiation for wavelengths within the wavelength range which is used for the application, and for lithography in particular, comprises a beam divergence perpendicular to said plane which is smaller than 5 mrad.

**2.** An illumination system as claimed in claim 1, **characterized in that** the source radiation for wavelengths within the wavelength range which is used for the application, and for lithography in particular, comprises in the marked plane a beam divergence < 100 mrad.

**3.** An illumination system as claimed in claim 1 to 2, **characterized in that** the illumination system comprises optical elements (206, 300, 400) for diverging a luminous beam perpendicular to the marked plane, which beam comes from the light source (1, 200).

**4.** An illumination system as claimed in one of the claims 1 to 3, **characterized in that** the source radiation for wavelengths within the wavelength range which is used for the application, and for lithography in particular, comprises in the marked plane a beam divergence which is smaller than 5 mrad.

**5.** An illumination system as claimed in one of the claims 1 to 4, **characterized in that** optical elements (206, 300, 400) are provided for diverging the luminous beam originating from the light source (1, 200) in the marked plane and perpendicular to the marked plane.

**6.** An illumination system as claimed in one of the claims 1 to 5, **characterized in that** the optical elements (206, 300, 400) comprise a dispersing mirror (400) or a dispersing lens for the purpose of diverging the luminous beam originating from the light source (1, 200).

**7.** An illumination system as claimed in claim 6, **characterized in that** the dispersing mirror (400) is a grazing-incidence mirror.

**8.** An illumination system as claimed in one of the claims 3 to 5, **characterized in that** the optical elements (206, 300, 400) comprise a scanning mirror for diverging the luminous beam originating from the light source (1, 200).

**9.** An illumination system as claimed in one of the claims 3 to 8, **characterized in that** optical elements (208, 302) are provided for collecting the diverged luminous beam.

**10.** An illumination system as claimed in one of the claims 1 to 9, **characterized in that** the source radiation comprises wavelengths in a region of 10 nm to 15 nm.

**11.** An illumination system as claimed in one of the claims 1 to 10, **characterized in that** the radiation source is a synchrotron radiation source.

**12.** An illumination system as claimed in claim 11, **characterized in that** the synchrotron radiation source comprises a wiggler or an undulator source.

13. An illumination system as claimed in one of the claims 1 to 12, **characterized in that** the raster elements (5, 102, 214) of the first mirror (7, 304, 402) produce the secondary light sources (218).

14. An illumination system as claimed in one of the claims 1 to 13, **characterized in that** the raster elements (102, 114) of the first mirror or the first lens (7, 304,402) which is broken down into raster elements are shaped and arranged in such a way that the images of the raster elements come to overlap by the optical elements (12, 32, 306, 308, 404, 406) predominantly in the image plane (14, 318) of the illumination system.

15. An illumination system as claimed in claim 14, **characterized in that** raster elements are shaped and arranged in such a way that exit pupil (24) of the illumination system as defined by aperture and degree of filling is illuminated.

16. An illumination system as claimed in one of the claims 9 to 15, **characterized in that** the optical elements for collecting the diverged luminous beam comprise at least one concave mirror or a focusing lens (208, 302).

17. An illumination system as claimed in claim 3 to 16, **characterized in that** the collector unit which comprises optical elements for diverging and/or collecting is configured in such a way that the first mirror (7, 304, 402) with raster elements (214) is illuminated in a nearly circular way.

18. An illumination system as claimed in one of the claims 3 to 17, **characterized in that** the collector unit which comprises optical elements for diverging and/or collecting projects the light source (1, 200) to a diaphragm plane (212).

19. An illumination system as claimed in one of the claims 13 to 18, **characterized in that** the raster elements (214) are arranged as planar facets.

20. An illumination system as claimed in claim 19, **characterized in that** the planar facets of the mirror (7, 304, 402) with raster elements (214) are arranged tilted on the mirror surface in such a way that the center rays of each planar facet meet in the image plane (14, 318) on an optical axis (222) which goes through the center of a field in the image plane to be illuminated.

21. An illumination system as claimed in one of the claims 13 to 18, **characterized in that** the raster elements (214) are prisms which are oriented and arranged in such a way that the center rays of each prism meet in the image plane (14, 318) on an optical axis which goes through the field center of the image plane.

22. An illumination system as claimed in claim 3 to 17, **characterized in that** the collector unit which comprises optical elements for collecting and/or diverging projects the light source (1, 200) into the image plane (14, 318).

23. An illumination system as claimed in claim 13 to 17, **characterized in that** the raster elements (214) have a collecting effect, such that secondary light sources (212, 1002) are formed in a diaphragm plane.

24. An illumination system as claimed in one of the claims 3 to 23, **characterized in that** the distance of the light source (200) to the optical elements for diverging the luminous beam (206, 300, 400) is not less than 2000 mm.

25. An illumination system as claimed in claim 24, **characterized in that** the distance of the optical elements for diverging the luminous beam (206, 300, 400) to the further lens system of the illumination system is not less than 1000 mm, which illumination system comprises means for collecting the luminous beam (208, 302), at least one mirror (402) which is broken down into raster elements as well as optical elements which project the secondary light sources (112, 216, 412, 1000) into the exit pupil of the illumination system.

26. An illumination system as claimed in claim 1 to 25, **characterized in that** all optical elements of the illumination system are arranged in such a way that the optical axis which extends at the radiation source in a horizontal plane is defected in such a way that the optical axis impinges upon an image plane (14, 318, 408) arranged in a horizontal plane under an angle between the normal line of the surface and optical axis at the image plane of not more than 20°, preferably not more than 10°.

27. An illumination system as claimed in one of the claims 1 to 15, **characterized in that** the raster elements (214) of the first mirror or the first lens (402) with raster elements are configured in such a way that as a result of the raster elements the collecting effect of the optical elements for collecting the luminous beam is represented.

**28.** An illumination system as claimed in claim 27, **characterized in that** the raster elements (214) of the first mirror (402) with raster elements on the mirror surface are arranged in a tilted manner in such a way that the center rays of each raster element meet in the image plane (14, 318) on an optical axis which passes through the center of the field to be illuminated in the image plane (14, 318).

**29.** An illumination system as claimed in claim 27 or 28, **characterized in that** the raster elements have a collecting effect, such that secondary light sources (112, 216,412,1000) are formed in a diaphragm plane (212).

**30.** An illumination system as claimed in claim 27, **characterized in that** the raster elements are prisms which are oriented and arranged in such a way that the center rays of each prism meet in the image plane (14, 318) on an optical axis which passes through the field center of the image plane (14, 318).

**31.** An illumination system as claimed in one of the claims 1 to 30, **characterized in that** the optical elements for diverging the luminous beam comprise a device with a mirror which can be moved in such a way that the luminous beam from the light source passes over a predetermined surface on the first mirror (7, 304, 402) with raster elements (214).

**32.** An illumination system as claimed in claim 31, **characterized in that** the predetermined surface is circular.

**33.** An illumination system as claimed in one of the claims 1 to 32, **characterized in that** two mirrors or lenses with raster elements are provided, with the first mirror or the first lens (7, 304, 402) comprising a plurality of raster elements which are designated as field honeycombs and with the second mirror or second lens comprising a plurality of raster elements which are designated as pupil honeycombs (9).

**34.** An illumination system as claimed in claim 33, **characterized in that** the pupil honeycombs (9) are arranged at the location of the secondary light sources (112, 216, 412, 1000).

**35.** An illumination system as claimed in one of the claims 33 to 34, **characterized in that** a field honeycomb is associated with each pupil honeycomb, and the pupil honeycombs project into the image plane the field honeycombs together with the optical elements which project the secondary light sources into the exit pupils.

**36.** An illumination system as claimed in one of the claims 33 to 35, **characterized in that** the field honeycombs on the first mirror or first lens (7, 304, 402) are arranged in such a way that they do not intersect and their images cover a surface area to be illuminated in the image plane (14, 318).

**37.** An illumination system as claimed in one of the claims 33 to 36, **characterized in that** as a result of a respective arrangement, especially rotation and tilting of reflective field and pupil honeycombs on the mirrors relative to each other, a light path is established between a pair of field and pupil honeycombs.

**38.** An illumination system as claimed in one of the claims 32 to 36, **characterized in that** as a result of orientation and selection of the deflection angle of the prismatic part of refractive field and pupil honeycomb of the lenses, a light path is established between a pair of field and pupil honeycombs.

**39.** An illumination system as claimed in one of the claims 1 to 38, **characterized in that** the optical elements comprise active lenses or mirrors for uniformity correction.

**40.** An illumination system as claimed in one of the claims 1 to 39, **characterized in that** at least one of the field mirrors is a wobbling field mirror.

**41.** An illumination system as claimed in one of the claims 1 to 40, **characterized in that** the raster elements or the first mirror or lens broken down into raster elements is arranged for reducing the honeycomb aspect as astigmatic field honeycombs.

**42.** A projection exposure system of microlithography

- with an illumination system as claimed in at least one of the claims 1 to 41;
- with a mask on a carrier system;
- with a projection lens;

- with a light-sensitive object on a carrier system.

**43.** A projection exposure system as claimed in claim 42, arranged as a scanning system.

**44.** A projection exposure system as claimed in at least one of the claims 42 to 43, **characterized in that** the luminous intensity on the light-sensitive object, in the case of a non-structured mask, is less than ± 5%, preferably less than ± 2%, of location-dependent differences.

**45.** A projection exposure system as claimed in one of the claims 42 to 43, **characterized in that** the scanning energy on the light-sensitive object, in the case of a non-structured mask, is less than ± 5%, preferably less than ± 2%, of location-independent differences.

**46.** A projection exposure system as claimed in at least one of the claims 42 to 45, **characterized in that** a vacuum window which is transparent for EUV is located in the beam path.

**47.** A projection exposure system as claimed in claim 46, **characterized in that** a vacuum window is arranged at a constriction of the luminous beam in the illumination system.

**48.** A method for producing microelectronic components, especially semiconductor chips with a projection exposure system as claimed in one of the claims 42 to 47.


**Revendications**

**1.** Système d'illumination pour des longueurs d'ondes ≤193 nm, notamment pour la lithographie EUV avec

1.1 au moins une source de lumière (1, 200)
1.2 au moins un dispositif destiné à générer des sources de lumière secondaires (218) comprenant au moins un premier miroir ou une première lentille (7, 9, 100, 304, 402) constitué(e) d'éléments de trame(5, 102, 214) ;
1.3 un ou plusieurs éléments optiques (12, 32, 306, 308, 404, 406) disposés entre le dispositif de miroirs ou de lentilles, comprenant au moins un premier miroir ou une première lentille (7, 9, 100, 304, 402) constitué(e) d'éléments de trame(5, 102, 214) et un plan image (14, 318, 408) du système d'illumination, les éléments optiques reproduisant les sources de lumière secondaires (218) sur une pupille de sortie (26, 320, 410) du système d'illumination ;
le système d'illumination étant **caractérisé en ce que**
1.4 la source de lumière (1, 200) est une source de lumière destinée à émettre un rayonnement possédant une longueur d'ondes ≤193 nm qui émet dans un plan marqué ayant un spectre de longueurs d'ondes, le rayonnement de la source pour des longueurs d'ondes de l'ordre de celles utilisées pour l'application, notamment pour la lithographie, présentant une divergence du faisceau perpendiculaire à ce plan qui est inférieure à 5 mrad.

**2.** Système d'illumination selon la revendication 1, **caractérisé en ce que** le rayonnement de la source pour des longueurs d'ondes de l'ordre de celles utilisées pour l'application, notamment pour la lithographie, dans le plan marqué présente une divergence du faisceau <100 mrad.

**3.** Système d'illumination selon la revendication 1 à 2, **caractérisé en ce que** le système d'illumination comprend des éléments optiques (206, 300, 400) destinés à faire diverger un faisceau de rayons partant de la source de lumière (1, 200) perpendiculairement au plan marqué.

**4.** Système d'illumination selon l'une quelconque des revendications 1 à 3, **caractérisé en ce que** le rayonnement de la source pour des longueurs d'ondes de l'ordre de celles utilisées pour l'application, notamment pour la lithographie, dans le plan marqué présente une divergence du faisceau qui est inférieure à 5 mrad.

**5.** Système d'illumination selon l'une quelconque des revendications 1 à 4, **caractérisé en ce que** sont prévus des éléments optiques (206, 300, 400) destinés à faire diverger le faisceau de rayons partant de la source de lumière (1, 200) dans le plan marqué et perpendiculairement au plan marqué.

**6.** Système d'illumination selon l'une quelconque des revendications 1 à 5, **caractérisé en ce que** les éléments optiques (206, 300, 400) destinés à faire diverger le faisceau de rayons partant de la source de lumière (1, 200) comprennent un miroir divergent (400), voire une lentille divergente.

**7.** Système d'illumination selon la revendication 6, **caractérisé en ce que** le miroir divergent (400) est un miroir à incidence rasante.

**8.** Système d'illumination selon l'une quelconque des revendications 3 à 5, **caractérisé en ce que** les éléments optiques (206, 300, 400) destinés à faire diverger le faisceau de rayons partant de la source de lumière (1, 200) comprennent un miroir de balayage.

**9.** Système d'illumination selon l'une quelconque des revendications 3 à 8, **caractérisé en ce que** sont prévus des éléments optiques (208, 302) destinés à faire converger le faisceau de rayons divergents.

**10.** Système d'illumination selon l'une quelconque des revendications 1 à 9, **caractérisé en ce que** le rayonnement de la source présente des longueurs d'ondes comprises entre 10 nm et 15 nm.

**11.** Système d'illumination selon l'une quelconque des revendications 1 à 10, **caractérisé en ce que** la source de rayonnement est une source de rayonnement synchrotron.

**12.** Système d'illumination selon la revendication 11, **caractérisé en ce que** la source de rayonnement synchrotron comprend un wiggler ou un ondulateur.

**13.** Système d'illumination selon l'une quelconque des revendications 1 à 12, **caractérisé en ce que** les éléments de trame(5, 102, 214) du premier miroir (7, 304, 402) génèrent les sources de lumière secondaires (218).

**14.** Système d'illumination selon l'une quelconque des revendications 1 à 13, **caractérisé en ce que** les éléments de trame(102, 114) du premier miroir ou de la première lentille (7, 304, 402) constitué(e) d'éléments de balayage, sont formés et agencés de telle sorte que les images des éléments de tramesont en majeure partie confondues dans le plan image (14, 318) du système d'illumination grâce aux éléments optiques (12, 32, 306, 308, 404, 406).

**15.** Système d'illumination selon la revendication 14, **caractérisé en ce que** les éléments de tramesont formés et disposés de telle sorte que la pupille de sortie (24) du système d'illumination, qui est définie par l'ouverture et le pourcentage d'illumination, est illuminée.

**16.** Système d'illumination selon l'une quelconque des revendications 9 à 15, **caractérisé en ce que** les éléments optiques destinés à faire converger le faisceau de rayons divergents comprend au moins un miroir convergent ou une lentille convergente (208, 302).

**17.** Système d'illumination selon les revendications 3 à 16, **caractérisé en ce que** l'ensemble collecteur comprenant des éléments optiques destinés à faire diverger et/ou converger est construit de telle sorte que l'illumination du premier miroir (7, 304, 402) comportant les éléments de trame(214) est pratiquement ronde.

**18.** Système d'illumination selon l'une quelconque des revendications 3 à 17, **caractérisé en ce que** l'ensemble collecteur comportant des éléments optiques destinés à faire diverger et/ou converger reproduit la source de lumière (1, 200) dans un plan du diaphragme (212).

**19.** Système d'illumination selon l'une quelconque des revendications 13 à 18, **caractérisé en ce que** les éléments de trame(214) sont conformés en forme de facettes planes.

**20.** Système d'illumination selon la revendication 19, **caractérisé en ce que** les facettes planes du miroir (7, 304, 402) comportant des éléments de trame(214) sont inclinées sur la surface du miroir de telle sorte que les rayons centraux de chaque facette plane se rencontrent dans le plan image (14 318) sur un axe optique (222) qui passe par le centre d'un champ situé dans le plan image et qu'il y a lieu d'illuminer.

**21.** Système d'illumination selon l'une quelconque des revendications 13 à 18, **caractérisé en ce que** les éléments de trame(214) sont des prismes qui sont orientés et agencés de telle sorte que les rayons centraux de chaque prisme se rencontrent dans le plan image (14, 318) sur un axe optique qui passe par le centre du champ situé dans le plan image.

**22.** Système d'illumination selon les revendications 3 à 17, **caractérisé en ce que** l'ensemble collecteur, qui comprend des éléments optiques pour faire converger et/ou diverger, reproduit la source de lumière (1, 200) dans le plan image (14, 318).

**23.** Système d'illumination selon les revendications 13 à 17, **caractérisé en ce que** les éléments de trame(214) ont un effet convergent tel que des sources de lumière secondaires (212, 1002) se forment dans un plan de diaphragme.

**24.** Système d'illumination selon l'une quelconque des revendications 3 à 23, **caractérisé en ce que** la distance séparant la source de lumière (200) des éléments optiques destinés à faire diverger le faisceau de rayons (206, 300, 400) est d'au moins 2000 mm.

**25.** Système d'illumination selon la revendication 24, **caractérisé en ce que** la distance séparant les éléments optiques destinés à faire diverger le faisceau de rayons (206, 300, 400) de l'optique restante du système d'illumination comprenant des moyens destinés à faire converger le faisceau de rayons (208, 302), au moins un miroir (402) constitué d'éléments de balayage, ainsi que des éléments optiques qui reproduisent les sources de lumière secondaires (112, 216, 412, 1000) dans la pupille de sortie du système d'illumination est d'au moins 1000 mm.

**26.** Système d'illumination selon l'une quelconque des revendications 1 à 25, **caractérisé en ce que** tous les éléments optiques du système d'illumination sont agencés de telle sorte que l'axe optique, qui, à la source de rayonnement, s'étend dans un plan horizontal, est dévié de manière à ce que l'axe optique rencontre un plan image (14, 318, 408) disposé dans un plan horizontal à un angle entre la normale de la surface et l'axe optique à la hauteur du plan image de 20° au plus, de préférence de 10° au plus.

**27.** Système d'illumination selon l'une quelconque des revendications 1 à 15, **caractérisé en ce que** les éléments de trame(214) du premier miroir ou de la première lentille (402) comportant des éléments de tramesont conformés de telle sorte que l'effet convergent des éléments optiques destinés à faire converger le faisceau de rayons est illustré par l'agencement des éléments de balayage.

**28.** Système d'illumination selon la revendication 27, **caractérisé en ce que** les éléments de trame(214) du premier miroir (402) comportant des éléments de tramesont inclinées sur la surface du miroir de telle sorte que les rayons centraux de chaque élément de tramese rencontrent dans le plan image (14, 318) sur un axe optique (222) qui passe par le centre d'un champ situé dans le plan image (14, 318) et qu'il y a lieu d'illuminer.

**29.** Système d'illumination selon la revendication 27 ou 28, **caractérisé en ce que** les éléments de trameont un effet convergent tel que des sources de lumière secondaires (112, 216, 412, 1000) se forment dans un plan de diaphragme (212).

**30.** Système d'illumination selon la revendication 27, **caractérisé en ce que** les éléments de tramesont des prismes qui sont orientés et agencés de telle sorte que les rayons centraux de chaque prisme se rencontrent dans le plan image (14, 318) sur un axe optique qui passe par le centre du champ situé dans le plan image (14, 318).

**31.** Système d'illumination selon l'une quelconque des revendications 1 à 30, **caractérisé en ce que** les éléments optiques destinés à faire diverger le faisceau de rayons comportent un dispositif avec un miroir, ce dispositif pouvant être déplacé de telle sorte que le faisceau de rayons provenant de la source de lumière couvre une surface prédéterminée du premier miroir (7, 304, 402) comportant les éléments de trame(214).

**32.** Système d'illumination selon la revendication 31, **caractérisé en ce que** la surface prédéterminée est ronde.

**33.** Système d'illumination selon l'une quelconque des revendications 1 à 32, **caractérisé en ce que** deux miroirs ou lentilles comportant des éléments de tramesont prévus, le premier miroir ou la première lentille (7, 304, 402) comprenant un grand nombre d'éléments de tramenommés alvéoles de champ et le deuxième miroir ou la deuxième lentille comprenant un grand nombre d'éléments de tramenommés alvéoles de pupille (9).

**34.** Système d'illumination selon la revendication 33, **caractérisé en ce que** les alvéoles de pupille (9) sont disposées à l'endroit des sources de lumière secondaires (112, 216, 412, 1000).

**35.** Système d'illumination selon l'une quelconque des revendications 33 à 34, **caractérisé en ce qu'**à chaque alvéole de pupille est associée une alvéole de champ et que les alvéoles de pupille reproduisent dans le plan image les alvéoles de champ ainsi que les éléments optiques qui reproduisent les sources de lumière secondaires dans la pupille de sortie.

**36.** Système d'illumination selon l'une quelconque des revendications 33 à 35, **caractérisé en ce que** les alvéoles de champ sont disposées sur le premier miroir ou la première lentille (7, 304, 402) de manière à ne pas se chevaucher et à ce que leurs images couvrent une surface qu'il y a lieu d'illuminer dans le plan image (14, 318).

**37.** Système d'illumination selon l'une quelconque des revendications 33 à 36, **caractérisé en ce que** l'on construit un chemin optique entre une paire d'alvéoles de champ et de pupille en disposant des alvéoles de champ et de pupille réflectives les unes par rapport aux autres sur les miroirs notamment en les tournant et en les basculant.

**38.** Système d'illumination selon l'une quelconque des revendications 32 à 36, **caractérisé en ce que** l'on construit un chemin optique entre une paire d'alvéoles de champ et de pupille en orientant et en choisissant l'angle de déviation de la portion prismatique d'alvéoles de champ et de pupille réfractives des lentilles.

**39.** Système d'illumination selon l'une quelconque des revendications 1 à 38, **caractérisé en ce que** les éléments optiques comprennent des lentilles ou des miroirs actifs pour la correction de l'uniformité (Uniformity Correction).

**40.** Système d'illumination selon l'une quelconque des revendications 1 à 39, **caractérisé en ce qu'**au moins un des miroirs de champ est un miroir de champ vobulateur.

**41.** Système d'illumination selon l'une quelconque des revendications 1 à 40, **caractérisé en ce que** les éléments de tramedu premier miroir ou de la première lentille constitué(e) d'éléments de tramesont conformés en forme d'alvéoles de champ astigmatiques en vue de réduire le rapport d'aspect des alvéoles.

**42.** Banc d'insolation par projection de microlithographie

- avec un système d'illumination selon l'une au moins des revendications 1 à 41
- un masque sur une platine support
- un objectif de projection
- un objet photosensible sur une platine support.

**43.** Banc d'insolation par projection selon la revendication 42, réalisé sous forme de système de balayage.

**44.** Banc d'insolation par projection selon l'une au moins des revendications 42 à 43, **caractérisé en ce que**, lorsque l'on utilise un masque dépourvu de structure, les différences d'intensité d'illumination de l'objet photosensible suivant les endroits sont inférieures à ± 5 %, de préférence inférieures à ± 2 %.

**45.** Banc d'insolation par projection selon l'une au moins des revendications 42 à 43, **caractérisé en ce que**, lorsque l'on utilise un masque dépourvu de structure, les différences de l'énergie de balayage sur l'objet photosensible indépendamment des endroits sont inférieures à ± 5 %, de préférence inférieures à ± 2 %.

**46.** Banc d'insolation par projection selon l'une au moins des revendications 42 à 45, **caractérisé en ce qu'**une fenêtre à vide laissant passer les EUV est disposée dans le trajet du faisceau.

**47.** Banc d'insolation par projection selon la revendication 46, **caractérisé en ce qu'**
une fenêtre à vide est disposée à la hauteur d'un rétrécissement du faisceau lumineux dans le système d'illumination.

**48.** Procédé de réalisation de composants microélectroniques, notamment de puces semi-conductrices moyennant un banc d'insolation par projection selon l'une quelconque des revendications 42 à 47.

## FIG.1

## FIG. 2A

## FIG.2B

*FIG.3*

*FIG.4*

*FIG.5*

*FIG.6*

FIG.7

FIG.8

FIG.9

FIG.10

FIG.11

FIG.12

_FIG. 13_

_FIG. 14_

_FIG. 15_

_FIG. 16_

*FIG. 17*

*FIG. 18*

$Du_{Feld}$

$Du_{Pupille}$

$NA_{Ret}$

*FIG. 19*

$Du_{Feld}$  $Du_{Pupille}$

$NA_{Ret}$

_FIG. 20_

$Du_{Pupille}$

$Du_{Feld}$

$NA_{Ret}$

_FIG.21_

200    206

208

216

$NA_{Quelle}$

A)

NA'

210

200    208    214    212

$NA_{Quelle}$    $DU_{Bi}$    218    222    220

206    NA'    NARET

B)    sek.LQ    RETIKEL

d1    d2    d3    d4    d5

## _FIG.22_

## _FIG. 23_

## _FIG. 24_

y

z

308

304

306

210

302

200

300

316

## _FIG. 25_

314

312

310

314

FIG. 26

Bel.-System mit Planfacetten-Spiegel

1000.00 MM

*FIG. 27*

308
306
318
320
302
304
300

500.00 MM

Bel.-System mit Planfacetten-Spiegel

FIG.28

531.91 MM

Bel.-System mit Planfacetten-Spiegel

FIG. 29

Bel.-System mit Planfacetten-Spiegel

500.00 MM

EP 1 076 906 B1

EP 1 076 906 B1

## Ausleuchtung des Retikelfeldes mit Planfacetten-Spiegel

_FIG. 30_

## FIG. 31

### Intensitätsverlauf in Scanrichtung

Y in der Retikelebene [mm]

Intensität [%]

Legend:
- x = 0.0
- x = 15.0
- x = 30.0
- x = 45.0

## FIG. 32

### Integrale Scanenergie in der Retikelebene

Scanenergie [%]

X in der Retikelebene [mm]

40

## FIG. 33

Bel-System mit Planfacetten-Spiegel

*FIG. 34*

Wabenspiegel im konv. Strahlengang

1000.00 MM

FIG. 35

Wabenspiegel im konv. Strahlengang

500.00 MM

FIG. 36

318
308
306
304
302
320
300

Wabenspiegel im konv. Strahlengang

543.48 MM

EP 1 076 906 B1

FIG. 37

Wabenspiegel im konv. Strahlengang

500.00 MM

EP 1 076 906 B1

Ausleuchtung des Retikelfeldes

mit Wabenplatte im konvergenten Strahlengang

*FIG. 38*

FIG. 39   Intensitätsverlauf in Scanrichtung
Refl. WaKo im konv. Strahlengang

FIG. 40   Integrale Scanenergie in der Retikelebene
Refl. WaKo im konv. Strahlengang mit
Feldlinse für 30°-Feld   Undulator-Quelle

FIG.41

FIG.42

FIG.43

FIG.44

**FIG.45**

Bel.-System mit fac. Kollektorspiegel

1000.00 MM

EP 1 076 906 B1

## FIG. 46

Bel.-System mit fac. Kollektorspiegel

500.00 MM

EP 1 076 906 B1

400

402

410

404

406

*FIG. 47*

x

z

Bel.-System mit fac. Kollektorspiegel

500.00 MM

FIG.48

Bel.-System mit fac.Kollektorspiegel

352.11 MM

*FIG. 49*

Bel.-System mit fac. Kollektorspiegel

500.00 MM

EP 1 076 906 B1

FIG.50

408

406

404

400

430

402

y

x

Bel.-System mit fac. Kollektorspiegel

250.00 mm

EP 1 076 906 B1

## FIG.51

Ausleuchtung des Retikelfeldes mit facettiertem Kollektorspiegel

# FIG.52

### Intensitätsverlauf in Scanrichtung
### Facettierter Kollektorspiegel

Legend:
- x = 0.0
- x = 15.0
- x = 30.0
- x = 45.0

Y axis: Intensität [%]
X axis: Y in der Retikelebene [mm]

# FIG.53

### Integrale Scanenergie in der Retikelebene
### Facettierter Kollektorspiegel

Y axis: Scanenergie [%]
X axis: X in der Retikelebene [mm]

## FIG.54

Facettierter Kollektorspiegel : Pupillenausleuchtung f.(0,0)

# FIG. 55

EP 1 076 906 B1

A) 1000

B) 1002 Du.Bi

1002 1002

d1 d2 d3 d4

NA RET RETIKEL